(19) Europäisches Patentamt
European Patent Office
Office européen des brevets

(11) EP 2 168 766 A1

(12) EUROPEAN PATENT APPLICATION

(43) Date of publication:
**31.03.2010 Bulletin 2010/13**

(21) Application number: **09012152.6**

(22) Date of filing: **24.09.2009**

(51) Int Cl.:
***B41C 1/10*** $^{(2006.01)}$ ***G03F 7/004*** $^{(2006.01)}$
***G03F 7/027*** $^{(2006.01)}$ ***G03F 7/038*** $^{(2006.01)}$
***G03F 7/075*** $^{(2006.01)}$ *C09C 1/30* $^{(2006.01)}$

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **26.09.2008 JP 2008249145**

(71) Applicant: **FUJIFILM Corporation**
**Minato-ku**
**Tokyo (JP)**

(72) Inventor: **Sasaki, Tomoya**
**Shizuoka (JP)**

(74) Representative: **HOFFMANN EITLE**
**Patent- und Rechtsanwälte**
**Arabellastrasse 4**
**81925 München (DE)**

(54) **Process for making lithographic printing plate**

(57) A process for making a lithographic printing plate is provided that includes an exposure step of imagewise exposing a lithographic printing plate precursor containing, above a hydrophilic support, a photosensitive layer that includes a binder polymer, an ethylenically unsaturated compound, a polymerization initiator, and organically modified particles (A) having a particle size of at least 1 nm but no greater than 100 nm, and a development processing step of carrying out development processing by one type of processing liquid having a pH of at least 2 but less than 11.

*FIG.1*

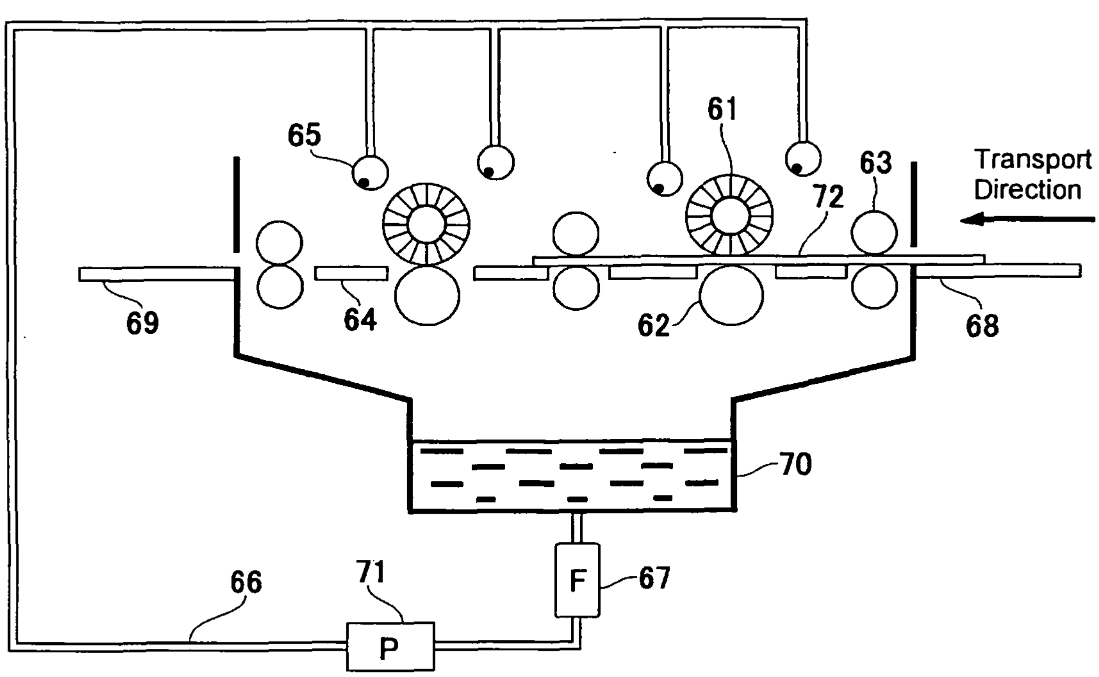


EP 2 168 766 A1

## Description

The present invention relates to a process for making a lithographic printing plate.

A lithographic printing plate conventionally comprises a photosensitive resin layer provided on a support having a hydrophilic surface. As for the plate-making method thereof, a desired printing plate is usually obtained by surface exposure (mask exposure) via a lith film and then removal of the non-image area with a developer. However, with the recent progress of digitization techniques, a computer-to-plate (CTP) technique of direct exposure on the plate surface by scanning according to digitized image data with highly directional light, for example, a laser beam, without using a lith film has been developed. Photosensitive lithographic printing plates (lithographic printing plate precursors) adapted for the technique have also been developed.

As the lithographic printing plate precursors suitable for exposure with a laser beam, lithographic printing plate precursors having a polymerizable photosensitive layer can be cited. Compared with other conventional photosensitive layers it is easy to increase the sensitivity in the polymerizable photosensitive layer by selecting a polymerization initiator or a polymerization initiation system (hereinafter also simply referred to as an 'initiator' and an 'initiation system').

As a laser light source, for example, a semiconductor laser of 405 nm or 830 nm or an FD-YAG laser can be used. In recent years, a CTP system equipped with a semiconductor laser of 405 nm has become widespread in view of the system cost and the handling properties.

As a lithographic printing plate precursor having high sensitivity and stable development processability, JP-A-2005-43660 (JP-A denotes a Japanese unexamined patent application publication) discloses development processing, using a developer comprising an inorganic alkali salt and a polyoxyalkylene ether group-containing nonionic surfactant and having a pH of 11.0 to 12.5, of a lithographic printing plate comprising unsaturated group-containing fine particles having an average particle size of 1 to 100 nm in a photosensitive layer.

In the conventionally known plate-making process for a lithographic printing plate precursor, after exposure as described above a step of removing unwanted image recording layer by dissolving with, for example, a developer is required, but the elimination or simplification of such an additional wet treatment can be cited as one problem. In particular, since in recent years the disposal of liquid waste discharged accompanying a wet treatment has become a great concern throughout the industrial field from the viewpoint of consideration for the global environment, the demand for a solution to the above-mentioned problem has been increasing more and more.

In response to the above-mentioned requirement, simple development processing with a weakly alkaline aqueous solution or a weakly acidic aqueous solution without using a strongly alkaline aqueous solution has been proposed as one simple plate-making method. In such development processing, an aqueous solution having a pH of 10 or less is usually used. For example, in U.S. Patent Application Publication No. 2004/0013968 there is described a processing method for a lithographic printing plate precursor that comprises preparing a lithographic printing plate precursor comprising (i) a hydrophilic support and (ii) an oleophilic heat-sensitive layer that comprises a radically polymerizable ethylenically unsaturated monomer, a radical polymerization initiator, and an infrared absorbing dye and that is cured by infrared laser exposure and is developable with an aqueous developer comprising 60 weight % or more of water and having a pH of 2.0 to 10.0, imagewise exposing the lithographic printing plate precursor to an infrared laser, and removing the uncured region of the heat-sensitive layer with the aqueous developer. Furthermore, JP-A-2007-316582 discloses a process for producing a lithographic printing plate comprising exposing to a 350 to 450 nm laser a lithographic printing plate precursor having, in order above a hydrophilic support, a photosensitive layer comprising (A) a sensitizing dye having an absorption maximum at 350 to 450 nm, (B) a polymerization initiator, (C) a polymerizable compound, and (D) a binder polymer, and a protective layer, and then removing the protective layer and the photosensitive layer of a non-exposed portion by means of an automatic processor equipped with a rubbing member by rubbing the plate surface with the rubbing member in the presence of a developer having a pH of 2 to 10.

In accordance with simple development type printing plates such as those described above, the amount of effluent decreases compared with a conventional strong alkali development type printing plate. Compared with development using a conventional strongly alkaline aqueous solution, the simple development type lithographic printing plate precursor suppresses exhaustion due to carbon dioxide, it is unnecessary to carry out pH control of the developer and replenishment of the developer, which are necessary for a strongly alkaline aqueous solution, and in theory a larger number of lithographic printing plate precursors than conventional can be processed. However, when a larger number of lithographic printing plate precursors than conventional are processed, if a hitherto known developer is used, a component originating from a photosensitive layer is deposited in the developer, and problems such as it being transferred to a printing plate or it adhering to a development bath to thus cause staining might occur.

It is an object of the present invention to provide, by means of a lithographic printing plate precursor having a photosensitive layer comprising a binder polymer, an ethylenically unsaturated compound, a polymerization initiator, and organically modified fine particles, a process for making a lithographic printing plate that has long plate life, excellent developability and staining properties, and can suppress the influence of development residue in a developer when carrying out simple development processing using a weakly alkaline aqueous solution or a weakly acidic aqueous

solution. In particular, when a weakly alkaline or weakly acidic developer is used, there is a serious problem with the staining properties of a printing plate precursor that, before actually being used, has been stored for a long period of time after the printing plate precursor is produced, and it is an important object to provide a process for making a lithographic printing plate for which the above defect has been improved.

The above-mentioned objects have been attained by means <1> below. It is described with <2> to <11>, which are preferred embodiments.

<1> A process for making a lithographic printing plate, comprising an exposure step of imagewise exposing a lithographic printing plate precursor that comprises, above a hydrophilic support, a photosensitive layer comprising a binder polymer, an ethylenically unsaturated compound, a polymerization initiator, and organically modified particles (A) having a particle size of at least 1 nm but no greater than 100 nm, and a development processing step of carrying out development processing by one type of processing liquid having a pH of at least 2 but less than 11,
<2> the process for making a lithographic printing plate according to <1> above, wherein the organically modified particles (A) are particles having on the particle surface an ethylenically unsaturated bond-containing group,
<3> the process for making a lithographic printing plate according to <1> or <2> above, wherein the organically modified particles (A) are organically modified silica particles,
<4> the process for making a lithographic printing plate according to any one of <1> to <3> above, wherein the organically modified particles (A) are organically modified particles represented by (1) below

$$P\text{-}[(Y)_s\text{-}\{(U^1)_p\text{-}(U^2\text{-}Z)_t\}_m]_k \qquad (1)$$

(in the formula, P denotes a particle support, Y denotes a coupling residue, k is an integer of 1 or more, m is an integer of 1 or more, s is 0 or 1, p is 0 or 1, t denotes an integer of 1 or more, $U^1$ denotes a first linking unit, $U^2$ denotes a second linking unit, and Z denotes a monovalent organic group),
<5> the process for making a lithographic printing plate according to any one of <1> to <4> above, wherein the photosensitive layer comprises a sensitizing dye,
<6> the process for making a lithographic printing plate according to <5> above, wherein the sensitizing dye is a cyanine dye,
<7> the process for making a lithographic printing plate according to <5> above, wherein the sensitizing dye is a dye represented by Formula (IX) below

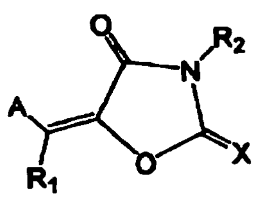

(IX)

(in Formula (IX), A denotes an optionally substituted aryl group or heterocyclic group, X denotes an oxygen atom, a sulfur atom, or $=N(R_3)$, $R_1$, $R_2$, and $R_3$ independently denote a monovalent non-metallic atomic group, and A and $R_1$ and/or $R_2$ and $R_3$ may be bonded to each other to form an aliphatic or aromatic ring),
<8> the process for making a lithographic printing plate according to <6> above, wherein the cyanine dye is a dye represented by Formula (a) below

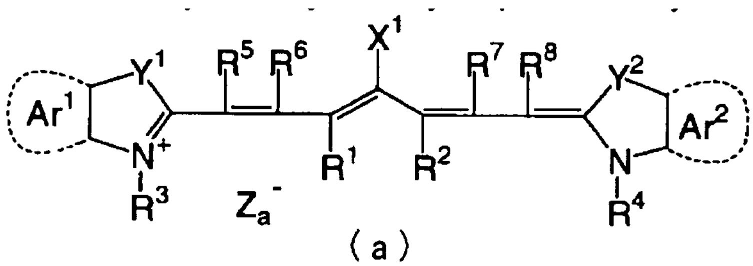

( a )

(in Formula (a), $X^1$ denotes a hydrogen atom, a halogen atom, $-NPh_2$, or an $-X^2-L^1$ group, $X^2$ denoting an oxygen atom, a nitrogen atom, or a sulfur atom and $L^1$ denoting a hydrocarbon group having 1 to 12 carbon atoms, a hetero atom-containing aromatic ring, or a hetero atom-containing hydrocarbon group having 1 to 12 carbon atoms,
$R^1$ and $R^2$ independently denote a hydrocarbon group having 1 to 12 carbon atoms,
$Ar^1$ and $Ar^2$ may be identical to or different from each other and denote an optionally substituted aromatic hydrocarbon group,
$Y^1$ and $Y^2$ may be identical to or different from each other and denote a sulfur atom or a dialkylmethylene group C (Rx)(Ry) having no greater than 12 carbon atoms,
Rx and Ry independently denote an alkyl group having 1 to 10 carbon atoms,
$R^3$ and $R^4$ may be identical to or different from each other and denote an optionally substituted hydrocarbon group having no greater than 20 carbon atoms,
$R^5$, $R^6$, $R^7$ and $R^8$ may be identical to or different from each other and denote a hydrogen atom or a hydrocarbon group having no greater than 12 carbon atoms, and
**Za$^-$** denotes a counteranion),
<9> the process for making a lithographic printing plate according to any one of <1> to <8> above, wherein the processing liquid is an aqueous solution comprising a water-soluble polymer compound,
<10> the process for making a lithographic printing plate according to any one of <1> to <9> above, wherein the development processing step is a step in which at least two of removal of a protective layer, removal of a non-exposed portion of the photosensitive layer, and gumming of the lithographic printing plate precursor are carried out in a single bath, and
<11> the process for making a lithographic printing plate according to any one of <1> to <10> above, wherein a water-washing step is not carried out either prior to or subsequent to the development processing step.

In accordance with the present invention, there can be provided, by means of a lithographic printing plate precursor having a polymerizable photosensitive layer, a process for making a lithographic printing plate, the process being capable of providing a lithographic printing plate having excellent developability and staining properties and long plate life even when carrying out simple development processing using a weakly alkaline or weakly acidic aqueous solution, and the process being capable of greatly suppressing staining after aging due to development residue in a developer even when development and gumming are carried out at the same time in a single liquid treatment.

Brief Description of Drawings

FIG. 1 is an explanatory diagram showing the structure of an automatic development processor.

Explanation of Reference Numerals and Symbols

61 Rotating brush roller
62 Backing roller
63 Transport roller
64 Transport guide plate
65 Spray pipe
66 Pipeline
67 Filter
68 Plate supply table
69 Plate discharge table
70 Developer tank
71 Circulating pump
72 Plate

The process for making a lithographic printing plate of the present invention is explained in detail below.

Lithographic printing plate precursor

In the present invention, an exposed lithographic printing plate precursor is developed using a developer having

a pH of at least 2.0 but less than 11.0, thus preparing a lithographic printing plate. A lithographic printing plate precursor that can be used suitably in the present invention is explained in detail below.

In accordance with an investigation by the present inventors, it has been found that when a large amount of particle-containing photosensitive layer is developed using a developer having a pH of at least 2 but less than 11, residue containing the particles as a main component is deposited in the developer, and this adheres to a printing plate to thus cause printing stains or sticks to a processor to thus cause staining. In contrast, by adding the above-mentioned organically modified particles to a photosensitive layer, even when development processing is carried out using a developer having a pH of at least 2 but less than 11, it is possible to suppress deposition of the particles and photosensitive layer components as a residue and suppress staining of a printing plate and staining after aging, and as a result a large number of lithographic printing plate precursors can be processed.

The pH of the developer is preferably 2 to 10, and the developer having a pH of 2 to 10 preferably contains carbonate ion or hydrogen carbonate ion.

## Photosensitive layer

The lithographic printing plate precursor that is used in the present invention comprises a photosensitive layer above a hydrophilic support, and the photosensitive layer comprises a binder polymer, an ethylenically unsaturated compound, a polymerization initiator, and organically modified particles (A) having a particle size of at least 1 nm but no greater than 100 nm. The photosensitive layer preferably comprises a sensitizing dye.

## Organically modified particles (A)

The photosensitive layer comprises organically modified particles (A) having particle size of at least 1 nm but no greater than 100 nm.

The organically modified particles referred to here are particles having an organic group at least on the particle surface.

The organically modified particles (A) that can be used in the present invention are preferably particles having at least on the particle surface an organic group having 2 or more carbon atoms, more preferably particles having at least on the particle surface an organic group having 2 to 60 carbon atoms, and yet more preferably particles having at least on the particle surface an organic group having 5 to 20 carbon atoms.

'Particle size' in the present invention means the average particle size of primary particles unless otherwise specified.

The particle size of the organically modified particles (A) is at least 1 nm but no greater than 100 nm, preferably at least 1 nm but no greater than 30 nm, and more preferably at least 10 nm but no greater than 20 nm.

The organically modified particles (A) are preferably particles having the particle surface thereof modified by a group having an ethylenically unsaturated bond, more preferably particles having the particle surface thereof modified by a group having a vinyl group, an allyl ether group, an acryloxy group, and/or a methacryloxy group, and yet more preferably particles having the particle surface thereof modified by a group having an acryloxy group and/or a methacryloxy group.

Furthermore, the organically modified particles (A) are preferably particles having the particle surface thereof modified by an organic group having 2 or more carbon atoms that is bonded to a silicon atom via a carbon atom.

The organically modified particles (A) are preferably organically modified inorganic particles, more preferably organically modified silica, titania, alumina, or zirconia particles, and yet more preferably organically modified silica particles.

Furthermore, the organically modified particles (A) are preferably particles whose surface has been modified by an organic group-containing silane coupling agent.

The organic group of the silane coupling agent is preferably an organic group having 2 or more carbon atoms, more preferably 2 to 60 carbon atoms, and yet more preferably 5 to 20 carbon atoms. Furthermore, the organic group of the silane coupling agent is preferably a group having an ethylenically unsaturated bond, and more preferably a group having an acryloxy group and/or a methacryloxy group.

The organic group-containing silane coupling agent is preferably a compound having only one organic group on the silicon atom, and more preferably a compound having one organic group and three alkoxy groups on the silicon atom.

Moreover, when preparing the organically modified particles (A), with regard to the ratio of the organically modified particles to the organic group-containing silane coupling agent used, the silane coupling agent is preferably 0.1 to 5.0 mmol per g of the particles, more preferably 0.5 to 3.5 mmol, and most preferably 1.0 to 2.0 mmol.

The organically modified particles used in the present invention are preferably organically modified particles having an average particle size of 1 to 100 nm and represented by Formula (1).

$$P\text{-}[(Y)_s\text{-}\{(U^1)_p\text{-}(U^2\text{-}Z)_t\}_m]_k \qquad (1)$$

In the formula, P denotes a particle support, Y denotes a coupling residue, k is an integer of 1 or more, m is an integer of 1 or more, s is 0 or 1, p is 0 or 1, and t denotes an integer of 1 or more. $U^1$ denotes a first linking unit, $U^2$ denotes a second linking unit, and Z denotes a monovalent organic group. When there are a plurality of monovalent organic groups denoted by Z, they are independently formed from carbon and non-metallic atoms. Specific examples thereof include optionally substituted alkyl, alkenyl, alkynyl, aryl, and heterocyclic groups. A divalent linking group formed from -C(Rx)(Ry)-, -O-, -S-, -N(Rz)-, -C(=O)-, or a combination thereof may be inserted into any carbon-carbon bond of the above structure. Here, Rx, Ry, and Rz independently denote a hydrogen atom, an alkyl group, an aryl group, or a heterocyclic group. Examples of the substituent include an alkyl group, an alkenyl group, an alkynyl group, an aryl group, a heterocyclic group, a halogen atom, a cyano group, a hydroxy group, and an alkoxy group. A heterocyclic group in the present invention is a monovalent group formed by removing one hydrogen atom from an aryl or non-aryl heterocyclic compound.

Z is preferably an ethylenically unsaturated bond-containing group, and when there are a plurality of Zs, among the Zs, at least one thereof is preferably an ethylenically unsaturated group. Examples of the ethylenically unsaturated group include a vinyl group, an allyl ether group, and an ester or amide residue of an unsaturated carboxylic acid such as acrylic acid, methacrylic acid, itaconic acid, crotonic acid, isocrotonic acid, or maleic acid, and an ester residue of acrylic acid or methacrylic acid is preferable.

Since the average particle size is as small as 100 nm or less, even when the particles are dispersed in a photosensitive layer, transparency can be maintained without causing cloudiness, etc., and there are no problems in terms of laser exposure, optical properties, etc. Furthermore, since the particle surface is covered with Z, that is, an ethylenically unsaturated bond-containing group, via a linking unit (collective term for $U^1$ and $U^2$), the particles are easily dispersed in an organic solvent, and can be used by mixing or dispersing in the same manner as for a usual reagent.

In Formula (1), P denotes a particle support, and specifically denotes an organic particle support, an inorganic particle support (e.g. silica, titania, alumina, or zirconia particles), etc. Among the above, silica or alumina is preferable, and silica is more preferable. Furthermore, the inorganic particle support preferably employs particles prepared by a sol-gel process. Moreover, it may be a reaction product between such a particle support and an active metal alkoxide.

The linking units $U^1$ and $U^2$ may be formed from a unit containing at least one type selected from various types of linking groups, for example, an open-chain hydrocarbon, a hydrocarbon ring, a hetero atom-containing open-chain hydrocarbon, a heterocycle, an oxygen atom, a sulfur atom, and a nitrogen atom. For example, the linking units $U^1$ and $U^2$ may be represented by the formulae below respectively.

$$-(R^1)_q\text{-}(B)_r\text{-}, \qquad -(R^2)_u\text{-}(Ar)_v\text{-}$$

(In the formulae, $R^1$ and $R^2$ may be identical to or different from each other and denote an alkylene group or an alkenylene group, B denotes an ester bond, a thioester bond, an amide bond, a urea bond, a urethane bond, a thiourethane bond, an imino group, a sulfur atom, or a nitrogen atom, and Ar denotes an optionally substituted (e.g. halogen atom, alkyl group, etc.) arylene or cycloalkylene group. q, r, u, and v denote 0 or 1, and $q+r+u+v \geq 1$.)

Y denotes a coupling residue connecting P and a linking unit, and specific examples thereof include a structure of a bonding moiety between a silane coupling agent and a particle surface, that is, a silicon atom-containing di- or higher-valent linking group.

Z denotes an ethylenically unsaturated bond-containing group, and examples thereof include acrylic acid, methacrylic acid, itaconic acid, crotonic acid, isocrotonic acid, maleic acid, etc. unsaturated carboxylic acid residues and acrylamide, etc. amide residues, but are not limited thereto.

Specific examples of the organically modified particles (A) that are used in the present invention include reaction products between various types of coupling agents and DeSolite Z7500 series particles Z7501, Z7503, Z7521, Z7522, Z7523, and Z7524 (Japan Synthetic Rubber Co., Ltd.) described in international publication WO02/46841 etc., IPA-ST, EG-ST, MEK-ST, MIBK-ST, PMA-ST, and PGM-ST methanol silica sols (Nissan Chemical Industries, Ltd.), PL-1-IPA, PL-1-MA, PL-2L-PGME, PL-2L-MEK, etc. organic solvent dispersion type silica sols (FUSO Chemical Co., Ltd.), organic solvent dispersion type titanium sols described in JP-A-2003-192348, international publication W02006-121121, etc., an organic solvent dispersion type aluminum sol such as Alumina Sol-10D (Kawaken Fine Chemicals Co., Ltd.), and an organic solvent dispersion type zirconia sol described in JP-A-2007-238422. The coupling agent is preferably a silane coupling agent. When various types of sols are in aqueous dispersion form, by adding an organic solvent and distilling off water an organic solvent dispersion may be formed and used.

The amount of these particles used is preferably in the range of 1 to 100 parts by weight, more preferably 3 to 50 parts by weight, and yet more preferably 5 to 30 parts by weight, relative to 100 parts by weight of ethylenically unsaturated compound, which is described later.

(A) Sensitizing dye

As a sensitizing dye contained in the photosensitive layer in the present invention, for example, adding a sensitizing dye having a maximum absorption at 300 to 450 nm, a sensitizing dye having a maximum absorption at 500 to 600 nm, or an IR absorber having a maximum absorption at 750 to 1,400 nm enables a high sensitivity lithographic printing plate precursor corresponding to a 405 nm violet laser, a 532 nm green laser, and an 803 nm IR laser, which are usually used in the present field, to be provided.
The sensitizing dye having a maximum absorption in the wavelength region of 300 to 450 nm is first explained.
Examples of such a sensitizing dye include a merocyanine dye, a benzopyran, a coumarin, an aromatic ketone, and an anthracene.
Among sensitizing dyes having an absorption maximum in the wavelength region of 300 to 450 nm, from the viewpoint of high sensitivity a dye represented by Formula (IX) below is more preferable.

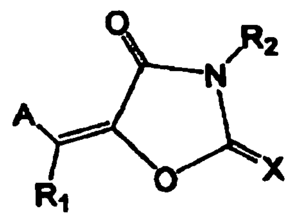
(IX)

(In Formula (IX), A denotes an optionally substituted aryl group or heterocyclic group, X denotes an oxygen atom, a sulfur atom, or =N($R_3$), $R_1$, $R_2$, and $R_3$ independently denote a monovalent non-metallic atomic group, and A and $R_1$, and/or $R_2$ and $R_3$ may be bonded to each other to form an aliphatic or aromatic ring.)
Formula (IX) is explained in further detail.
$R_1$, $R_2$, and $R_3$ in Formula (IX) are independently a monovalent non-metallic atomic group, and preferably a substituted or unsubstituted alkyl group, a substituted or unsubstituted alkenyl group, a substituted or unsubstituted aryl group, a substituted or unsubstituted heterocyclic group, a substituted or unsubstituted alkoxy group, a substituted or unsubstituted alkylthio group, a hydroxyl group, or a halogen atom.
A in Formula (IX) is now explained.
A denotes an optionally substituted aryl group or heterocyclic group, and specific examples of the optionally substituted aromatic ring or heterocycle include the same as those described for $R_1$, $R_2$, and $R_3$ in Formula (IX).
Preferred specific examples of such a sensitizing dye include compounds described in paragraphs 0047 to 0053 of JP-A-2007-58170.
Furthermore, a sensitizing dye represented by Formulae (V) to (VII) below may also be used.

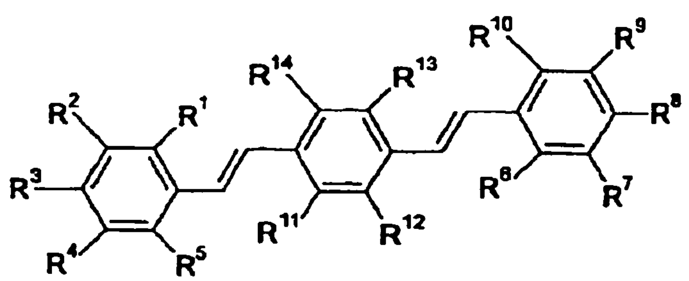
(V)

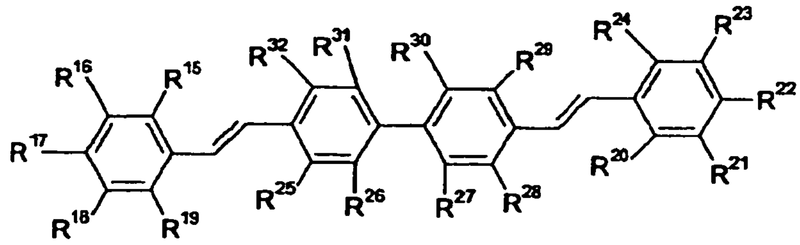

(VI)

In Formula (V), $R^1$ to $R^{14}$ independently denote a hydrogen atom, an alkyl group, an alkoxy group, a cyano group, or a halogen atom. At least one of $R^1$ to $R^{10}$ denotes an alkoxy group having 2 or more carbons.

In Formula (VI), $R^{15}$ to $R^{32}$ independently denote a hydrogen atom, an alkyl group, an alkoxy group, a cyano group, or a halogen atom. At least one of $R^{15}$ to $R^{24}$ denotes an alkoxy group having 2 or more carbons.

Preferred specific examples of such a sensitizing dye include compounds described in EP-A-1349006 and WO2005/029187.

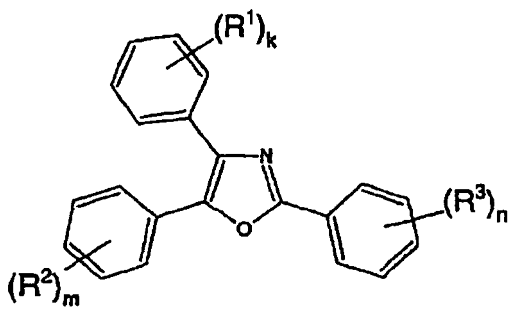

(VII)

In Formula (VII), $R^1$, $R^2$, and $R^3$ independently a halogen atom, an alkyl group, an aryl group, an aralkyl group, an $-NR^4R^5$ group, or an $-OR^6$ group, $R^4$, $R^5$, and $R^6$ independently denote a hydrogen atom, an alkyl group, an aryl group, or an aralkyl group, and k, m, and n independently denote an integer of 0 to 5.

Preferred specific examples of such a sensitizing dye include compounds described in WO2004/074930.

Furthermore, sensitizing dyes described in JP-A-2007-171406, JP-A-2007-206216, JP-A-2007-206217, JP-A-2007-225701, JP-A-2007-225702, JP-A-2007-316582, and JP-A-2007-328243 may also preferably be used.

The amount of sensitizing dye added is preferably 0.05 to 30 parts by weight relative to 100 parts by weight of the total solids content of the photosensitive layer, more preferably 0.1 to 20 parts by weight, and yet more preferably 0.2 to 10 parts by weight.

The sensitizing dye having a maximum absorption at 750 to 1,400 nm that is suitably used in the photosensitive layer in the present invention is now explained in detail below.

The sensitizing dye used here attains an electronically excited state with high sensitivity by irradiation with (exposure to) an IR laser, and it is surmised that electron transfer, energy transfer, generation of heat (photo-thermal conversion), etc. related to the electronically excited state acts on a polymerization initiator present in the photosensitive layer so as to cause a chemical change of the polymerization initiator, thus generating an active species such as a radical, an acid, or a base. Whichever is the case, adding a sensitizing dye having a maximum absorption at 750 to 1,400 nm is particularly suitable for print-making of directly drawing an image using an IR laser having a wavelength of 750 nm to 1,400 nm, and compared with a conventional lithographic printing plate precursor, high image formation performance can be exhibited.

The sensitizing dye (IR absorber) is preferably a dye having an absorption maximum in the wavelength region of 750 nm to 1,400 nm.

As the dye, commercial dyes and known dyes described in the literature such as, for example, 'Senryo Binran' (Dye Handbook) (Ed. The Society of Synthetic Organic Chemistry, Japan, 1970) may be used. Specific examples thereof include an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt, and a metal thiolate complex.

Among these dyes, a cyanine dye, a squarylium dye, a pyrylium salt, a nickel thiolate complex, and an indolenine

cyanine dye are preferable.

As the sensitizing dye, a cyanine dye and an indolenine cyanine dye are more preferable, and a cyanine dye represented by Formula (a) below is particularly preferable.

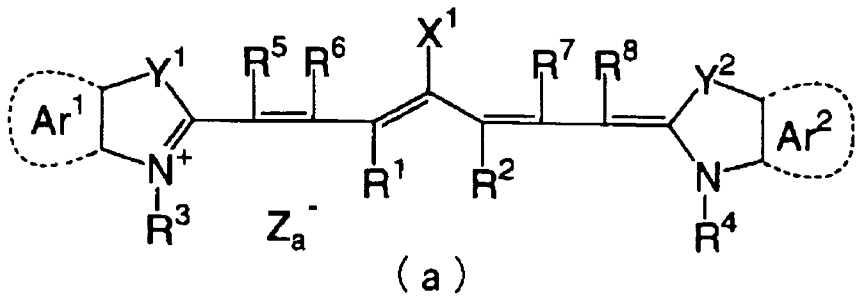

(a)

In Formula (a), $X^1$ denotes a hydrogen atom, a halogen atom, $-NPh_2$, $-X^2-L^1$, or the group shown below. Here, $X^2$ denotes an oxygen atom, a nitrogen atom, or a sulfur atom, $L^1$ denotes a hydrocarbon group having 1 to 12 carbons, a hetero atom-containing aromatic ring, or a hetero atom-containing hydrocarbon group having 1 to 12 carbons. The hetero atom referred to here means N, S, O, a halogen atom, or Se, and Ph denotes a phenyl group.

$X_a^-$ is defined in the same manner as for $Z_a^-$, which is described later, and $R^a$ denotes a hydrogen atom or a substituent selected from the group consisting of an alkyl group, an aryl group, a substituted or unsubstituted amino group, and a halogen atom.

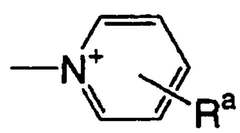

$X_a^-$

$R^1$ and $R^2$ independently denote a hydrocarbon group having 1 to 12 carbons. From the viewpoint of storage stability of a photosensitive layer coating liquid, $R^1$ and $R^2$ are preferably hydrocarbon groups having two or more carbons, and it is also preferable for $R^1$ and $R^2$ to be bonded to each other to form a 5-membered ring or a 6-membered ring.

$Ar^1$ and $Ar^2$ may be identical to or different from each other, and denote an optionally substituted aromatic hydrocarbon group. Preferred examples of the aromatic hydrocarbon group include a benzene ring and a naphthalene ring. Preferred examples of the substituent include a hydrocarbon group having not more than 12 carbons, a halogen atom, and an alkoxy group having not more than 12 carbons.

$Y^1$ and $Y^2$ may be identical to or different from each other, and denote a sulfur atom or a dialkylmethylene group C(Rx)(Ry) having no greater than 12 carbon atoms.

Rx and Ry independently denote an alkyl group having 1 to 10 carbon atoms.

$R^3$ and $R^4$ may be identical to or different from each other, and denote an optionally substituted hydrocarbon group having not more than 20 carbons. Preferred examples of the substituent include an alkoxy group having not more than 12 carbons, a carboxy group, and a sulfo group.

$R^5$, $R^6$, $R^7$, and $R^8$ may be identical to or different from each other, and denote a hydrogen atom or a hydrocarbon group having not more than 12 carbons. From the availability of starting materials, a hydrogen atom is preferable.

Furthermore, $Za^-$ denotes a counteranion. When a cyanine dye represented by Formula (a) has an anionic substituent in its structure and neutralization of charge is unnecessary, Za- is not required. From the viewpoint of storage stability of the photosensitive layer coating liquid, Za- is preferably a halide ion, a perchlorate ion, a tetrafluoroborate ion, a hexafluorophosphate ion, or a sulfonate ion, and particularly preferably a perchlorate ion, a hexafluorophosphate ion, or an arylsulfonate ion. As a counterion, one not containing a halide ion is particularly preferable.

As a pigment, commercial pigments and pigments described in 'Karaa Indekkusu (C.I.) Binran' (Color Index Handbook), 'Saishin Ganryo Binran' (Latest Pigments Handbook) (Ed. Nippon Ganryo Gijutsu Kyokai, 1977), 'Saishin Ganryo Ouyo Gijutsu' (Latest Pigment Application Techniques) (CMC Publishing, 1986), and 'Insatsu Inki Gijutsu' (Printing Ink Techniques) (CMC Publishing, 1984) may be used.

Examples of the type of pigment include a black pigment, a yellow pigment, an orange pigment, a brown

pigment, a red pigment, a purple pigment, a blue pigment, a green pigment, a fluorescent pigment, a metal powder pigment and, in addition, polymer-binding dyes. Specifically, an insoluble azo pigment, an azo lake pigment, a condensed azo pigment, a chelate azo pigment, a phthalocyanine type pigment, an anthraquinone type pigment, perylene and perinone type pigments, a thioindigo type pigment, a quinacridone type pigment, a dioxazine type pigment, an isoindolinone type pigment, a quinophthalone type pigment, a dye lake pigment, an azine pigment, a nitroso pigment, a nitro pigment, a natural pigment, a fluorescent pigment, an inorganic pigment, carbon black, etc. may be used. Among these pigments, carbon black is preferable.

These pigments may be used with or without a surface treatment being carried out. As a method for the surface treatment, a method in which the surface is coated with a resin or wax, a method in which a surfactant is deposited, a method in which a reactive material (e.g. a silane coupling agent, an epoxy compound, a polyisocyanate, etc.) is bonded to the pigment surface, etc. can be considered. The above-mentioned surface treatment methods are described in 'Kinzoku Sekken no Seishitsu to Ouyo' (Properties and Applications of Metal Soaps) (SAIWAISHOBO), 'Insatsu Inki Gijutsu' (Printing Ink Techniques) (CMC Publishing, 1984), and 'Saishin Ganryo Ouyo Gijutsu' (Latest Pigment Application Techniques) (CMC Publishing, 1986).

The particle size of the pigment is preferably in the range of 0.01 μm to 10 μm, more preferably in the range of 0.05 μm to 1 μm, and particularly preferably in the range of 0.1 μm to 1 μm. In this preferred particle size range, the dispersion stability of the pigment in the photosensitive layer is excellent and a uniform photosensitive layer can be obtained.

As a method for dispersing the pigment, a known dispersion technique used for ink production, toner production, etc. may be used. Examples of a dispersion machine include an ultrasonic disperser, a sand mill, an attritor, a pearl mill, a super mill, a ball mill, an impeller, a disperser, a KD mill, a colloidal mill, a dynatron, a three roll mill, and a pressure kneader. Details are described in 'Saishin Ganryo Ouyo Gijutsu' (Latest Pigment Application Techniques) (CMC Publishing, 1986).

These IR absorbers may be added to the same layer as other components or may be added to another layer provided separately.

From the viewpoint of uniformity in the photosensitive layer and durability of the photosensitive layer, the amount of these IR absorbers added is preferably 0.01 to 50 wt % relative to the total content of solids forming the photosensitive layer, and more preferably 0.1 to 10 wt %; in the case of a dye it is particularly preferably 0.5 to 10 wt %, and in the case of a pigment it is particularly preferably 0.1 to 10 wt %.

These sensitizing dyes may be used singly or in a combination of two or more types. In the case that there arises such a problem as crystallization or precipitation after coating, or unstable dispersibility in a developer particularly when the sensitizing dye is used singly, it may be preferable that sensitizing dyes having the same skeleton with different substituents are used in combination. Mixture of sensitizing dyes having different main skeletons may also be used.

When sensitizing dyes are used in mixture, each sensitizing dye added is preferably at at least 0.5 parts by weight, more preferably at at least 1 part by weight, yet more preferably at at least 3 parts by weight relative to 100 parts by weight of the total sensitizing dyes.

Polymerization initiator

The photosensitive layer in the present invention contains a polymerization initiator (hereinafter, also called an 'initiator compound').

An initiator compound is a compound that undergoes chemical change by actions such as electron transfer, energy transfer, or generation of heat caused by the electronically excited state of a sensitizing dye to thus generate at least one type selected from a radical, an acid, or a base. Hereinafter, a radical, an acid, and a base thus generated are simply called 'active species'. When there is no initiator compound or only an initiator compound is used on its own, in practice sufficient sensitivity cannot be obtained. As one mode in which a sensitizing dye and an initiator compound are used in combination, they may be made into a single compound by an appropriate chemical method (linking the sensitizing dye and the initiator compound by a chemical bond, etc.) and used.

It is surmised that many of these initiator compounds usually form an active species via initial chemical processes represented by (1) to (3) below. That is, (1) reductive decomposition of an initiator compound based on an electron transfer reaction from a sensitizing dye in an electronically excited state to the initiator compound, (2) oxidative decomposition of an initiator compound based on electron transfer from the initiator compound to a sensitizing dye in an electronically excited state, and (3) decomposition of an initiator compound in an electronically excited state based on energy transfer from a sensitizing dye in an electronically excited state to the initiator compound. Although there is often some ambiguity with respect to which individual initiator compound belongs to which type of (1) to (3), the sensitizing dye in the present invention exhibits a very high sensitizing effect in combination with any type of these initiator compounds.

As the initiator compound, a compound known to a person skilled in the art may be used without any restrictions,

and specific examples thereof include a trihalomethyl compound, a carbonyl compound, an organic peroxide, an azo type compound, an azide compound, a metallocene compound, a hexaarylbiimidazole compound, an organic boron compound, a disulfone compound, an oxime ester compound, an onium salt compound, and an iron arene complex. Among them, it is preferably at least one type selected from the group consisting of a hexaarylbiimidazole-based compound, an onium salt, a trihalomethyl compound, and a metallocene compound, and it is particularly preferably a hexaarylbiimidazole-based compound.

Furthermore, the polymerization initiator may be used in a combination of two or more types as appropriate.

As the hexaarylbiimidazole compound, there can be cited lophine dimers described in JP-B-45-37377 and JP-B-44-86516 (JP-B denotes a Japanese examined patent application publication), and examples thereof include 2,2'-bis (*o*-chlorophenyl)-4,4',5,5'-tetraphenylbiimidazole, 2,2'-bis(o-bromophenyl)-4,4',5,5'-tetraphenylbiimidazole, 2,2'-bis(*o*, *p*-dichlorophenyl)-4,4',5,5'-tetraphenylbiimidazole, 2,2'-bis(*o*-chlorophenyl)-4,4',5,5'-tetra(*m*-methoxyphenyl)biimidazole, 2,2'-bis(*o,o*'-dichlorophenyl)-4,4',5,5'-tetraphenylbiimidazole, 2,2'-bis(*o*-nitrophenyl)-4,4',5,5'-tetraphenylbiimidazole, 2,2'-bis(*o*-methylphenyl)-4,4',5,5'-tetraphenylbiimidazole, and 2,2'-bis(*o*-trifluorophenyl)-4,4',5,5'-tetraphenylbiimidazole. The hexaarylbiimidazole-based compound is particularly preferably used in combination with a sensitizing dye having a maximum absorption at 300 to 450 nm.

Preferred examples of the onium salt (functioning as an ionic polymerization initiator in the present invention, not as an acid generator) in the present invention include a sulfonium salt, an iodonium salt and/or a diazonium salt, and particularly preferred are a diaryliodonium salt and/or a triarylsulfonium salt. Furthermore, it is particularly preferable that the onium salt is used in combination with an IR absorber having a maximum absorption at 750 nm to 1,400 nm.

Examples of the onium salt suitably used in the present invention are represented by Formulae (RI-I) to (RI-III) below.

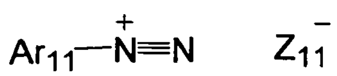

(RI - I)

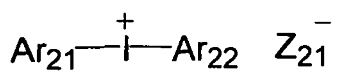

(RI - II)

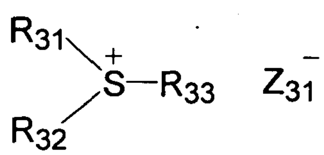

(RI - III)

In Formula (RI-I), $Ar_{11}$ denotes an aryl group that has not more than 20 carbons and that may have 1 to 6 substituents. Preferable examples of the substituent include an alkyl group having 1 to 12 carbons, an alkenyl group having 1 to 12 carbons, an alkynyl group having 1 to 12 carbons, an aryl group having 1 to 12 carbons, an alkoxy group having 1 to 12 carbons, an aryloxy group having 1 to 12 carbons, a halogen atom, an alkylamino group having 1 to 12 carbons, a dialkylamino group having 1 to 12 carbons, an alkylamide group or arylamide group having 1 to 12 carbons, a carbonyl group, a carboxy group, a cyano group, a sulfonyl group, a thioalkyl group having 1 to 12 carbons, and a thioaryl group having 1 to 12 carbons.

In Formula (RI-I), $Z_{11}^-$ denotes a monovalent anion. Specific examples of the monovalent anion include a halide ion, a perchlorate ion, a hexafluorophosphate ion, a tetrafluoroborate ion, a sulfonate ion, a sulfinate ion, a thiosulfonate ion, or a sulfate ion. Among them, a perchlorate ion, a hexafluorophosphate ion, a tetrafluoroborate ion, a sulfonate ion, and a sulfinate ion are preferable from the viewpoint of stability.

In Formula (RI-II), $Ar_{21}$ and $Ar_{22}$ independently denote an aryl group that has not more than 20 carbons and that may have 1 to 6 substituents. Preferable examples of the substituent include an alkyl group having 1 to 12 carbons, an alkenyl group having 1 to 12 carbons, an alkynyl group having 1 to 12 carbons, an aryl group having 1 to 12 carbons, an alkoxy group having 1 to 12 carbons, an aryloxy group having 1 to 12 carbons, a halogen atom, an alkylamino group having 1 to 12 carbons, a dialkylamino group having 1 to 12, an alkylamide group or arylamide group having 1 to 12 carbons, a carbonyl group, a carboxy group, a cyano group, a sulfonyl group, a thioalkyl group having 1 to 12 carbons, or a thioaryl group having 1 to 12 carbons.

In Formula (RI-II), $Z_{21}^-$ denotes a monovalent anion. Specific examples of the monovalent anion include a

halogen ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity.

In Formula (RI-III), $R_{31}$, $R_{32}$, and $R_{33}$ independently denote an aryl group that has not more than 20 carbons and that may have 1 to 6 substituents, an alkyl group, an alkenyl group, or an alkynyl group. Among them, the aryl group is preferable from the viewpoint of reactivity and stability.

Examples of the substituent include an alkyl group having 1 to 12 carbons, an alkenyl group having 1 to 12 carbons, an alkynyl group having 1 to 12 carbons, an aryl group having 1 to 12 carbons, an alkoxy group having 1 to 12 carbons, an aryloxy group having 1 to 12 carbons, a halogen atom, an alkylamino group having 1 to 12 carbons, a dialkylamino group having 1 to 12 carbons, an alkylamide group or arylamide group having 1 to 12 carbons, a carbonyl group, a carboxy group, a cyano group, a sulfonyl group, a thioalkyl group having 1 to 12 carbons, and a thioaryl group having 1 to 12 carbons.

In Formula (RI-III), $Z_{31}^-$ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity. Carboxylate ions described in JP-A-2002-148790 and JP-A-2001-343742 are more preferable, and carboxylate ions described in JP-A-2002-148790 are particularly preferable.

The onium salt is particularly preferably used in combination with an IR absorber having a maximum absorption at 750 to 1,400 nm.

As other polymerization initiators, polymerization initiators described in JP-A-2007-171406, JP-A-2007-206216, JP-A-2007-206217, JP-A-2007-225701, JP-A-2007-225702, JP-A-2007-316582, and JP-A-2007-328243 may preferably be used.

With regard to the polymerization initiator in the present invention, one type thereof may suitably used on its own or two or more types thereof may be used in combination.

The amount of polymerization initiator used in the photosensitive layer in the present invention is preferably 0.01 to 20 wt % relative to the total weight of the solids content of the photosensitive layer, more preferably 0.1 to 15 wt %, and yet more preferably 1.0 to 10 wt %.

<u>Ethylenically unsaturated compound (hereafter also called as 'Polymerizable compound')</u>

An ethylenically unsaturated compound used in the photosensitive layer according to the present invention is an addition-polymerizable compound having at least one ethylenically unsaturated double bond, and is selected from compounds having at least one, and preferably two or more, terminal ethylenically unsaturated double bonds. Such compounds are widely known in the art and they can be used in the present invention without any particular limitation. The compound has the chemical form of, for example, a monomer or a prepolymer and, specifically, a dimer, a trimer or an oligomer, or a copolymer thereof, or a mixture thereof. Examples of the monomer include an unsaturated carboxylic acid (for example, acrylic acid, methacrylic acid, itaconic acid, crotonic acid, isocrotonic acid, or maleic acid) and an ester or amide thereof, and an ester of an unsaturated carboxylic acid with a polyhydric alcohol compound or an amide of an unsaturated carboxylic acid with a polyvalent amine compound is preferably used. An addition reaction product of an unsaturated carboxylic acid ester or amide having a nucleophilic substituent such as a hydroxy group, an amino group, or a mercapto group with a monofunctional or polyfunctional isocyanate or epoxy compound, or a dehydration condensation reaction product of an unsaturated carboxylic acid ester or amide having a nucleophilic substituent with a monofunctional or polyfunctional carboxylic acid is also suitably used. Moreover, an addition reaction product of an unsaturated carboxylic acid ester or amide having an electrophilic substituent such as an isocyanate group or an epoxy group with a monofunctional or polyfunctional alcohol, amine, or thiol, or a substitution reaction product of an unsaturated carboxylic acid ester or amide having a leaving group such as a halogen group or a tosyloxy group with a monofunctional or polyfunctional alcohol, amine, or thiol is also suitably used. In addition, compounds in which the unsaturated carboxylic acid described above is replaced by an unsaturated phosphonic acid, styrene, vinyl ether, etc. can also be used.

Specific examples of monomers that are esters of a polyhydric alcohol compound with an unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, ethylene oxide (EO)-modified isocyanurate triacrylate, and polyester acrylate oligomer.

As methacrylic acid esters there can be cited tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[*p*-(3-methacryloxy-2-hydroxypropoxy)phenyl]dimethylmethane, and bis[*p*-(methacryloxyethoxy)phenyl]dimethylmethane.

As itaconic acid esters there can be cited ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

As crotonic acid esters there can be cited ethylene glycol dicrotonate, tetramethylene glycol dicrotonate, pentaerythritol dicrotonate, and sorbitol tetra-dicrotonate.

As isocrotonic acid esters there can be cited ethylene glycol diisocrotonate, pentaerythritol diisocrotonate, and sorbitol tetraisocrotonate.

As maleic acid esters there can be cited ethylene glycol dimaleate, triethylene glycol dimaleate, pentaerythritol dimaleate, and sorbitol tetramaleate.

Other examples of esters that can be suitably used include aliphatic alcohol esters described in JP-B-51-47334 and JP-A-57-196231, esters having an aromatic skeleton described in JP-A-59-5240, JP-A-59-5241, and JP-A-2-226149, and esters containing an amino group described in JP-A-1-165613.

The above-mentioned ester monomers can also be used as a mixture.

Specific examples of monomers that are amides of a polyvalent amine compound with an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide, and xylylenebismethacrylamide. Other preferred examples of the amide monomer include amides having a cyclohexylene structure described in JP-B-54-21726.

Urethane-based addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by Formula (A") below to a polyisocyanate compound having two or more isocyanate groups per molecule, described in JP-B-48-41708.

$$CH_2{=}C(R_4)COOCH_2CH(R_5)OH \qquad (A")$$

($R_4$ and $R_5$ independently denote H or $CH_3$.)

Moreover, urethane acrylates described in JP-A-51-37193, JP-B-2-32293, and JP-B-2-16765, and urethane compounds having an ethylene oxide skeleton described in JP-B-58-49860, JP-B-56-17654, JP-B-62-39417 and JP-B-62-39418 are suitably used. Furthermore, a photopolymerizable composition having remarkably high photosensitive speed can be obtained by using an addition polymerizable compound having an amino structure or a sulfide structure in its molecule, described in JP-A-63-277653, JP-A-63-260909, and JP-A-1-105238.

Furthermore, a photo-oxidizable polymerizable compound described in JP-PCT-2007-506125 (JP-PCT denotes a published Japanese translation of a PCT application) is suitably used, and a polymerizable compound having at least one urea group and/or one tertiary amino group is particularly preferable. Specific examples include a compound shown below.

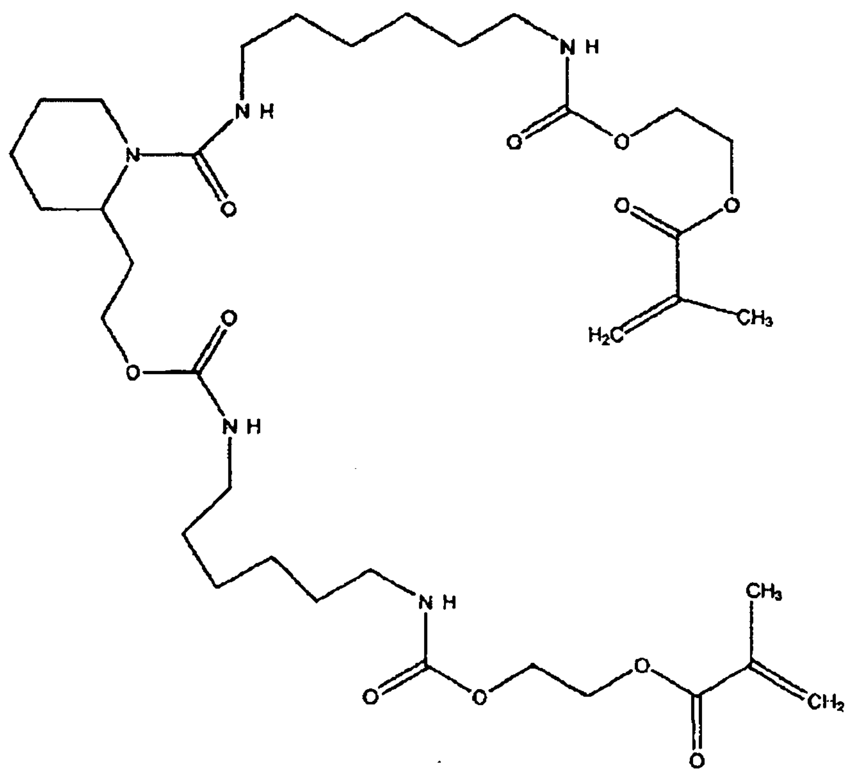

Other examples include polyfunctional acrylates and methacrylates, for example, polyester acrylates and epoxy acrylates obtained by reacting an epoxy resin with (meth)acrylic acid, described in JP-A-48-64183, JP-B-49-43191, and JP-B-52-30490. Specific unsaturated compounds described in JP-B-46-43946, JP-B-1-40337, and JP-B-1-40336, and vinylphosphonic acid-based compounds described in JP-A-2-25493 can also be cited. In some cases, a structure containing a perfluoroalkyl group described in JP-A-61-22048 can be suitably used. Moreover, photocurable monomers or oligomers described in Nippon Secchaku Kyokaishi (Journal of Japan Adhesion Society), Vol. 20, No. 7, pp. 300-308 (1984) can also be used.

Details of a method for using the ethylenicaly unsaturated compound, for example, selection of the structure, single or combined use, or amount added, can be appropriately determined in accordance with the characteristic design of the final lithographic printing plate precursor. For example, the compound is selected from the following standpoints.

From the viewpoint of sensitivity, a structure having a large unsaturated group content per molecule is preferable, and in many cases, a di- or higher-functional compound is preferable. Also, in order to increase the strength of the image area, that is, the cured film, a tri- or higher-functional compound is preferable. The combined use of compounds different in the number of functional groups or in the type of polymerizable group (for example, an acrylic acid ester, a methacrylic acid ester, a styrene compound, or a vinyl ether compound) is an effective method for controlling both sensitivity and strength.

The selection and method of use of the polymerizable compound are also important factors for compatibility and dispersibility with other components (for example, a binder polymer, a polymerization initiator, or a colorant) in the photosensitive layer. For example, compatibility may be improved in some cases by using a compound of low purity or by using two or more types of compounds in combination. A specific structure may be selected for the purpose of improving adhesion to a support and a protective layer which is described below, etc. Besides, in the method of using the polymerizable compound, appropriate structure, combination, and amount added can be freely selected by taking account of the degree of polymerization inhibition due to oxygen, resolution, fogging properties, change in refractive index, surface tackiness, etc. Furthermore, depending on the case, the layer construction, for example, an undercoat layer or an overcoat layer, and the coating method may also be considered.

The amount of ethylenically unsaturated compound used in the photosensitive layer is preferably 5 to 75 wt % relative to the total solids content of the photosensitive layer, more preferably 25 to 70 wt %, and yet more preferably 30 to 60 wt %.

(D) Binder polymer

The photosensitive layer of the lithographic printing plate precursor preferably further employs a binder polymer in addition to the above-mentioned polymerization initiator and ethylenically unsaturated compound.
The binder polymer is a polymer that functions as a film-forming agent of the photosensitive layer, and preferably comprises a linear organic polymer. As such a 'linear organic polymer', a known polymer may be used.
Preferred examples of such a binder polymer include polymers selected from the group consisting of a (meth) acrylic resin, a polyvinylacetal resin, a polyurethane resin, a polyamide resin, an epoxy resin, a styrene-based resin, and a polyester resin. Among them, a (meth)acrylic resin and a polyurethane resin are preferable. The '(meth)acrylic resin' referred to here means a (meth)acrylic polymer having a (meth)acrylic acid derivative as a (co)polymer component. The 'polyurethane resin' referred to here means a polymer formed by a condensation reaction of a compound having two isocyanate groups and a compound having two or more hydroxyl groups.
The 'polyvinyl acetal resin' referred to here means a polymer which is synthesized from the reaction between polyvinyl alcohol obtained by partial or complete saponification of polyvinyl acetate, and an aldehyde compound under the acidic condition (acetalization reaction), and further includes a polymer with an acidic group, etc., introduced by such a means of reacting the remaining hydroxyl group with a compound having an acidic group, etc. In particular, when a butylaldehyde is used as an aldehyde, it is called 'polyvinyl butyral resin'.
Furthermore, crosslinking properties may be imparted to the binder polymer in order to increase the film strength of the image area.
In order to impart crosslinking properties to the binder polymer, a crosslinkable functional group such as an ethylenically unsaturated bond, is introduced into a main chain or side chain of the polymer. The crosslinkable functional group may be introduced by copolymerization or a polymer reaction.
The term 'crosslinkable group' as used herein means a group capable of crosslinking the binder polymer in the process of a radical polymerization reaction caused in the photosensitive layer when the lithographic printing plate precursor is exposed. The crosslinkable group is not particularly restricted as long as it has such a function and includes, for example, an ethylenically unsaturated bond group, an amino group, or an epoxy group as a functional group capable of undergoing an addition polymerization reaction. Also, a functional group capable of forming a radical upon irradiation with light may be used and such a crosslinkable group includes, for example, a thiol group, a halogeno group, and an onium salt structure. Among them, the ethylenically unsaturated bond group is preferable, and functional groups represented by Formulae (1') to (3') below are particularly preferable.

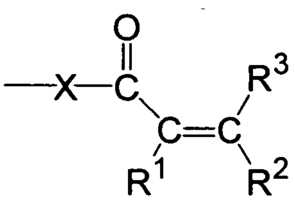

(1')

In Formula (1') above, $R^1$ to $R^3$ independently denote a hydrogen atom or a monovalent group.
Examples of $R^1$ preferably include a hydrogen atom or an optionally substituted alkyl group. Among them, a hydrogen atom or a methyl group is preferable because of high radical reactivity.
$R^2$ and $R^3$ independently denote a hydrogen atom, a halogen atom, an amino group, a carboxy group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, an optionally substituted arylsulfonyl group, etc. Among them, a hydrogen atom, a carboxy group, an alkoxycarbonyl group, an optionally substituted alkyl group, or an optionally substituted aryl group is preferable because of high radical reactivity.
X denotes an oxygen atom, a sulfur atom, or -N($R^{12}$)-, and $R^{12}$ denotes a hydrogen atom or a monovalent organic group. Here, examples of $R^{12}$ include an optionally substituted alkyl group. Among them, a hydrogen atom, a methyl group, an ethyl group, or an isopropyl group is preferable because of high radical reactivity.
Examples of the substituent that can be introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amide group, an alkylsulfonyl group, and an arylsulfonyl group.

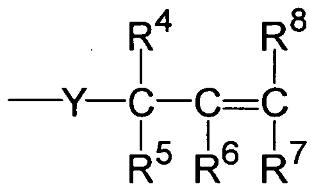

(2')

In Formula (2') above, $R^4$ to $R^8$ independently denote a hydrogen atom or a monovalent group.

Examples of $R^4$ to $R^8$ preferably include a hydrogen atom, a halogen atom, an amino group, a dialkylamino group, a carboxy group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group. Among them, a hydrogen atom, a carboxy group, an alkoxycarbonyl group, an optionally substituted alkyl group, or an optionally substituted aryl group is preferable.

Examples of the substituent that can be introduced include those described for Formula (1').

Y denotes an oxygen atom, a sulfur atom, or $N(R^{12})$. $R^{12}$ has the same meaning as $R^{12}$ defined in Formula (1'), and preferred examples thereof are also the same.

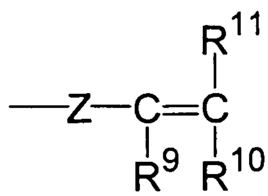

(3')

In Formula (3') above, $R^9$ to $R^{11}$ independently denote a hydrogen atom or a monovalent group.

$R^9$ preferably denotes a hydrogen atom or an optionally substituted alkyl group. Among them, a hydrogen atom or a methyl group is preferable because of high radical reactivity.

Examples of $R^{10}$ and $R^{11}$ independently include a hydrogen atom, a halogen atom, an amino group, a dialkylamino group, a carboxy group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group. Among them, a hydrogen atom, a carboxy group, an alkoxycarbonyl group, an optionally substituted alkyl group, or an optionally substituted aryl group is preferable because of high radical reactivity.

Examples of the substituent that can be introduced include those described in Formula (1').

Z denotes an oxygen atom, a sulfur atom, $N(R^{13})$, or an optionally substituted phenylene group.

$R^{13}$ denotes an optionally substituted alkyl group, etc. Among them, a methyl group, an ethyl group, or an isopropyl group is preferable because of high radical reactivity.

Among the polymers, a (meth)acrylic acid copolymer and a polyurethane, each of which has a crosslinkable group in a side chain, are more preferable.

In the binder polymer having crosslinking properties, for example, a free radical (a polymerization initiating radical or a propagating radical in the process of polymerization of the polymerizable compound) is added to the crosslinkable functional group to cause addition-polymerization between polymers directly or through a polymerization chain of the polymerizable compound; as a result, crosslinking is formed between polymer molecules to effect curing. Alternatively, an atom (for example, a hydrogen atom on a carbon atom adjacent to the functional crosslinkable group) in the polymer is abstracted by a free radical to produce a polymer radical, and polymer radicals combine with each other to form crosslinking between polymer molecules to effect curing.

The content of the crosslinkable group (content of radically polymerizable unsaturated double bond determined by iodine titration) in the binder polymer is preferably 0.1 to 10.0 mmol, more preferably 1.0 to 7.0 mmol, and most preferably 2.0 to 5.5 mmol, per g of the binder polymer.

Furthermore, the binder polymer used is appropriately selected according to the mode of development processing so that a non-image area of the photosensitive layer is removed well in a plate making process for the lithographic printing plate precursor. Details are described below.

Alkali-soluble binder polymer

In a mode in which development processing is carried out using an alkali developer having a pH of more than 7 but less than 11, since it is necessary to dissolve a binder polymer in an alkali developer having a pH of more than 7 but less than 11, an organic polymer that is soluble in an aqueous alkali having a pH of more than 7 but not more than 10 is preferably used, and an organic polymer that is soluble in an aqueous alkali having a pH of 8 to 10 is more preferably used.
It is preferable for the binder polymer to have an alkali-soluble group such that it can be dissolved in an aqueous alkali having a pH of more than 7 but less than than 11. The alkali-soluble group is preferably an acid group, and examples thereof include a carboxy group, a sulfonic acid group, a phosphoric acid group, and a hydroxy group. Among them, from the viewpoint of achieving a balance between film-forming properties, plate life, and developability, a binder polymer having a carboxy group is particularly preferable.
Moreover, the alkali-soluble binder polymer may be given crosslinking properties as described above in order to improve film strength of an image area. In order to impart crosslinking properties to the binder polymer, a crosslinkable functional group such as an ethylenically unsaturated bond may be introduced into a main chain or a side chain of the polymer. The crosslinkable functional group may be introduced by copolymerization or a polymer reaction.
The alkali-soluble binder polymer preferably has a weight-average molecular weight of 5,000 or more, and more preferably 10,000 to 300,000, and a number-average molecular weight of 1,000 or more, and more preferably 2,000 to 250,000. The polydispersity (weight-average molecular weight/number-average molecular weight) is preferably 1.1 to 10.
The alkali-soluble binder polymer may be any of a random polymer, a block polymer, a graft polymer, etc., and is preferably a random polymer.
The alkali-soluble binder polymer may be used singly or in a combination of two or more types as a mixture.
The content of the alkali-soluble binder polymer is preferably 5 to 90 wt % relative to the total solids content of the photosensitive layer, more preferably 10 to 70 wt %, and yet more preferably 10 to 60 wt %. In the above-mentioned range, good strength for an image area and good image formation properties are obtained.

Hydrophilic group-containing binder polymer

As a binder polymer that can be used in the photosensitive layer, in order to improve developability by the developer, a binder polymer having a hydrophilic group (hydrophilic group-containing binder polymer) may be used. In particular, when an acidic to weakly alkaline developer is used, a hydrophilic group-containing binder polymer is preferably used.
The hydrophilic group is selected from monovalent and di- or higher-valent hydrophilic groups, and preferred examples thereof include a hydroxy group, a sulfonic acid group, a carboxylic acid group, a phosphoric acid group, an alkyleneoxy group such as an ethyleneoxy group or a propyleneoxy group, a primary amino group, a secondary amino group, a tertiary amino group, a salt formed by neutralizing an amino group with an acid, a quaternary ammonium group, a sulfonium group, an iodonium group, a phosphonium group, an amide group, an ether group, and a salt formed by neutralizing an acid group such as a carboxylic acid, sulfonic acid, or phosphoric acid; particularly preferred examples thereof include a primary amino group, a secondary amino group, a tertiary amino group, a salt formed by neutralizing an amino group with an acid, a quaternary ammonium group, an amide group, a hydroxy group, a $-CH_2CH_2O-$ repeating unit, a $-CH_2CH_2NH-$ repeating unit, and a salt formed by neutralizing an acid group with an amino group-containing compound, and most preferred examples thereof include a tertiary amino group, a salt formed by neutralizing an acid group with an amino group-containing compound, a salt formed by neutralizing an amino group with an acid, and a quaternary ammonium group.
The hydrophilic group-containing binder polymer is preferably a copolymer, and from the viewpoint of developability the proportion of the copolymer component having a hydrophilic group described above in the total copolymer components of the copolymer is preferably 1 to 70% relative to the total monomer units forming the copolymer, and from the viewpoint of a balance being achieved between developability and plate life it is preferably 1 to 50% and particularly preferably 1 to 30%.
With regard to the skeleton of such a hydrophilic group-containing binder polymer, a polymer selected from the group consisting of an acrylic resin, a polyvinylacetal resin, a polyvinyl alcohol resin, a polyurethane resin, a polyamide resin, an epoxy resin, a methacrylic resin, a styrene resin, and a polyester resin is preferable. Among them, a vinyl copolymer such as an acrylic resin, a methacrylic resin, or a styrene resin or polyurethane resin is particularly preferable.
The hydrophilic group-containing binder polymer preferably has the type of crosslinkable group described above.
The content of the crosslinkable group (content of radically polymerizable unsaturated double bond determined by iodine titration) in the hydrophilic group-containing binder polymer is preferably 0.01 to 10.0 mmol, more preferably

0.05 to 5.0 mmol, and yet more preferably 0.1 to 2.0 mmol, per g of the hydrophilic group-containing binder polymer.

From the viewpoint of further improvement of plate life, the crosslinkable group is desirably in the vicinity of the hydrophilic group, and the hydrophilic group and the crosslinkable group may be present on the same polymerization unit.

The hydrophilic group-containing binder polymer preferably has, in addition to the above-mentioned hydrophilic group-containing unit, crosslinkable group-containing unit, and hydrophilic group- and crosslinkable group-containing unit, an alkyl or aralkyl (meth)acrylate unit. The alkyl group of the alkyl (meth)acrylate is preferably an alkyl group having 1 to 5 carbons, and more preferably a methyl group. Examples of the aralkyl (meth)acrylate include benzyl (meth)acrylate.

The hydrophilic group-containing binder polymer preferably has a weight-average molecular weight of 5,000 or more, and more preferably of 10,000 to 300,000, and a number-average molecular weight of 1,000 or more, and more preferably 2,000 to 250,000. The polydispersity (weight-average molecular weight/number-average molecular weight) is preferably 1.1 to 10.

The hydrophilic group-containing binder polymer may be any of a random polymer, a block polymer, a graft polymer, etc.

The hydrophilic group-containing binder polymer may be used singly or in a combination of two or more thereof.

From the viewpoint of strength of the image area and good image-forming properties, the content of the hydrophilic group-containing binder polymer is preferably 5 to 75 wt %, more preferably 10 to 70 wt %, and yet more preferably 10 to 60 wt %, relative to the total solids content of the photosensitive layer.

Furthermore, the total content of the polymerizable compound and the binder polymer is preferably not more than 80 wt % relative to the total solids content of the photosensitive layer, and more preferably 35 to 75 wt %. In the above-mentioned range, sensitivity and developability are excellent.

Specific examples of polymerization units constituting the hydrophilic group-containing binder polymer and specific examples of the hydrophilic group-containing binder polymer are shown below, but the present invention is not limited by these examples. Weight-average molecular weight (Mw, also expressed simply as 'molecular weight' in the table below) in the table below is measured by gel permeation chromatography (GPC) using polystyrene as a reference material. In the chemical formulae below, TsO$^-$ is an abbreviation for *p*-$CH_3C_6H_4SO_3^-$, and a formulation ratio is mol ratio.

| Polymer No. | Binder structure (mol %) | Molecular weight |
|---|---|---|
| P - 1 | 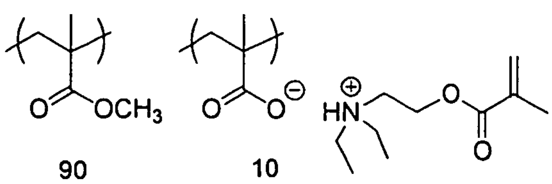 90 10 | 80,000 |
| P - 2 | 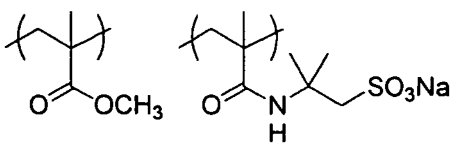 95 5 | 72,000 |

| Polymer No. | Diisocyanate compound used (mol%) | Diol compound used (mol%) | Molecular weight |
|---|---|---|---|
| P-3 | 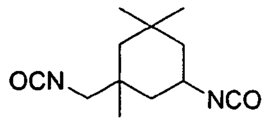 70 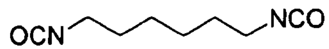 30 | 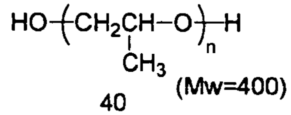 40 (Mw=400) 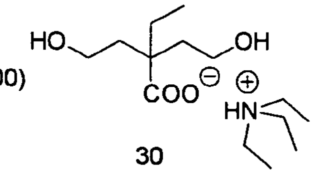 30 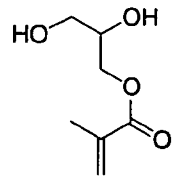 30 | 60,000 |

| Polymer No. | Polymer structure (mol %) | Molecular weight |
|---|---|---|
| P - 4 | 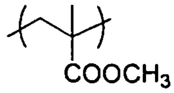 90 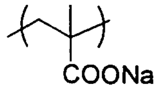 10 | 50,000 |
| P - 5 | 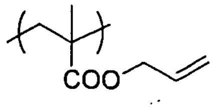 90 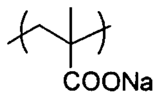 10 | 60,000 |
| P - 6 | 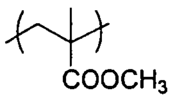 65 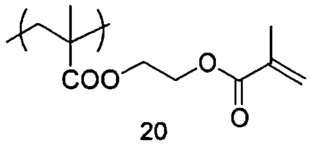 20 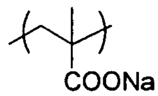 15 | 65,000 |
| P - 7 | 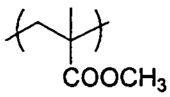 85 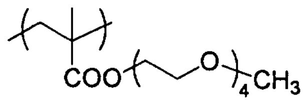 10 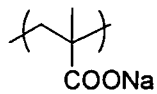 5 | 60,000 |
| P - 8 | 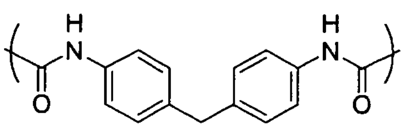 40 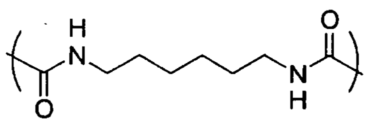 10<br>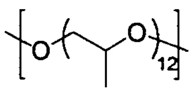 20 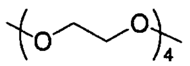 20 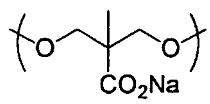 10 | 63,000 |
| P - 9 | 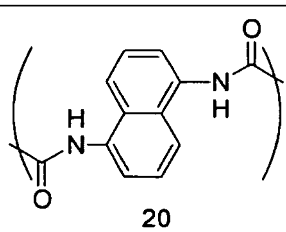 20 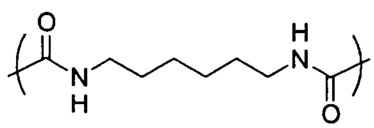 30<br>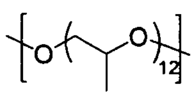 20 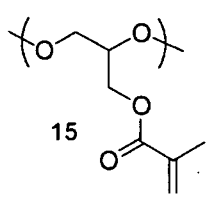 15 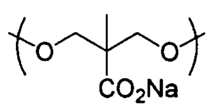 15 | 60,000 |

| Polymer No. | Polymer structure | Formulation ratio | Molecular weight |
|---|---|---|---|
| P - 10 | 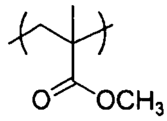 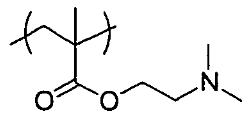 | 90/10 | 70,000 |
| P - 11 | 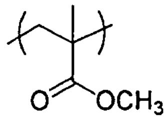 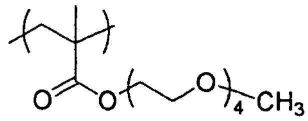 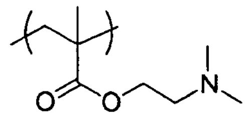 | 90/5/5 | 80,000 |
| P - 12 | 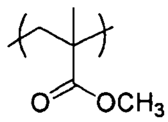 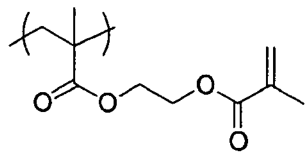 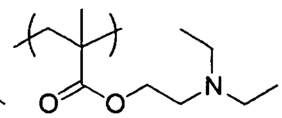 | 60/35/5 | 80,000 |

| Polymer No. | Diisocyanate compound used (mol %) | Diol compound used (mol %) | Molecular weight |
|---|---|---|---|
| P - 13 | 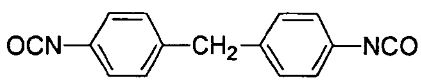 80 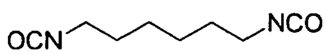 20 | 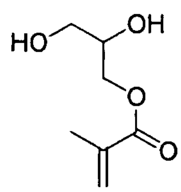 30 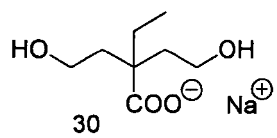 30 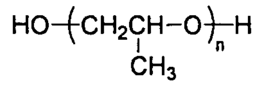 40 (Mw=400) | 57,000 |

| Polymer No. | Polymer structure | Formulation ratio | Molecular weight |
| --- | --- | --- | --- |
| P - 14 | 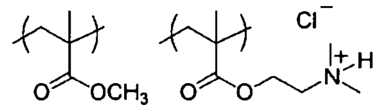 | 90/10 | 70,000 |
| P - 15 | 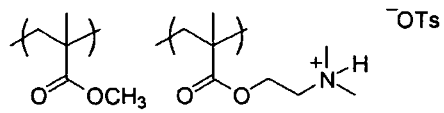 | 90/10 | 58,000 |
| P - 16 | 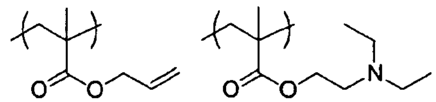 | 90/10 | 90,000 |
| P - 17 | 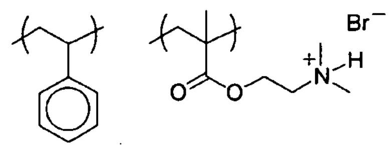 | 70/30 | 62,000 |
| P - 18 | 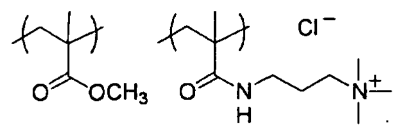 | 70/30 | 58,000 |
| P - 19 | 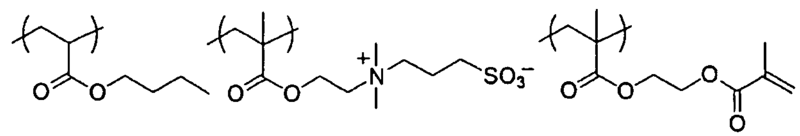 | 50/25/25 | 49,000 |

| Polymer | Diisocyanate structure (mol%) | | Diol structure (mol%) | | | Mw |
|---|---|---|---|---|---|---|
| P-20 | 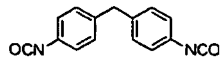 40 | 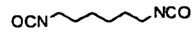 10 | $HO\text{-}(CH_2CH(CH_3)\text{-}O)_n\text{-}H$ | 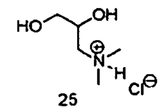 25 | 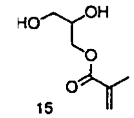 15 | 59, 000 |
| P-21 | 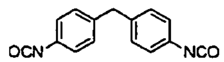 40 | 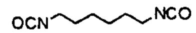 10 | 10 (Mw=1000) $HO\text{-}(CH_2CH(CH_3)\text{-}O)_n\text{-}H$ | 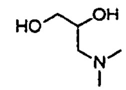 25 | 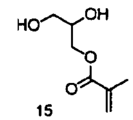 15 | 59, 000 |
| P-22 | 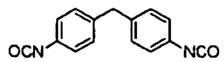 40 | 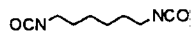 10 | 10 (Mw=1000) $HO\text{-}(CH_2CH(CH_3)\text{-}O)_n\text{-}H$ | 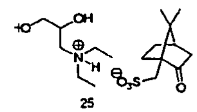 25 | 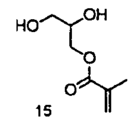 15 | 62,000 |
| P-23 | 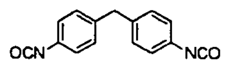 40 | 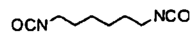 10 | 10 (Mw=1000) 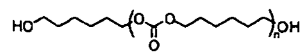 10 | 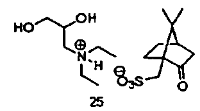 25 | 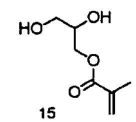 15 | 53,000 |

| Polymer No. | Binder structure (mol %) | Molecular weight |
|---|---|---|
| P - 24 | 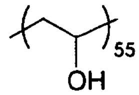 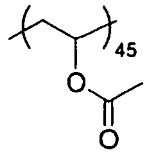 | 80,000 |
| P - 25 | 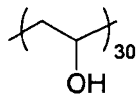 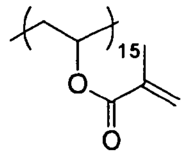 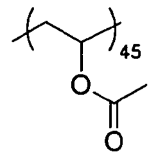 | 100,000 |

In the present invention, by adjusting the ratio of a polymerizable compound to a binder polymer, penetration of a developer into the photosensitive layer is enhanced, and thus developability is further improved. Therefore, the weight ratio of the total polymerizable compound to the total binder polymer is preferably at least 1.2, more preferably from 1.25 to 4.5, and yet more preferably from 2 to 4.

Microcapsules

In the present invention, as a method by which the above-mentioned constituents of the photosensitive layer and other constituents described hereinafter are contained in the photosensitive layer, part of the constituents may be encapsulated in microcapsules and added to the photosensitive layer as described in, for example, JP-A-2001-277740 and JP-A-2001-277742. In such a case, each constituent may be present inside or outside the microcapsule in any appropriate ratio.

As a method of microencapsulating the constituents of the photosensitive layer, known methods can be used.

Methods for the production of microcapsules include, for example, a method utilizing coacervation described in U.S. Pat. Nos. 2,800,457 and 2,800,458, a method using interfacial polymerization described in U.S. Pat. No. 3,287,154, JP-B-38-19574, and JP-B-42-446, a method using polymer deposition described in U.S. Pat. Nos. 3,418,250 and 3,660,304, a method using an isocyanate polyol wall material described in U.S. Pat. No. 3,796,669, a method using an isocyanate wall material described in U.S. Pat. No. 3,914,511, a method using a urea-formaldehyde type or urea-formaldehyde-resorcinol type wall-forming material described in U.S. Pat. Nos. 4,001,140, 4,087,376, and 4,089,802, a method using a wall material, for example, a melamine-formaldehyde resin or hydroxycellulose described in U.S. Pat. No. 4,025,445, an in-situ method by monomer polymerization described in JP-B-36-9163 and JP-B-51-9079, a spray drying method described in GB Patent No. 930,422 and U.S. Pat. No. 3,111,407, and an electrolytic dispersion cooling method described in GB Patents Nos. 952,807 and 967,074, but the present invention should not be construed as being limited thereto.

A preferred microcapsule wall has three-dimensional crosslinking and has the property of being swollen by solvent. From this point of view, preferred wall materials of the microcapsule include polyurea, polyurethane, polyester, polycarbonate, polyamide, and mixtures thereof, and polyurea and polyurethane are particularly preferred. Furthermore, a compound having a crosslinkable functional group such as an ethylenically unsaturated bond, capable of being introduced into above-mentioned water-insoluble polymer, may be introduced into the microcapsule wall.

The average particle size of the microcapsules is preferably 0.01 to 3.0 μm, more preferably 0.05 to 2.0 μm, and particularly preferably 0.10 to 1.0 μm. In the above-mentioned range, good resolution and stability over time can be achieved.

Colorant

The photosensitive layer may employ a dye having a large absorption in the visible light region as a colorant for the image.

Specific examples of the dye include Oil Yellow #101, Oil Yellow #103, Oil Pink #312, Oil Green BG, Oil Blue BOS, Oil Blue #603, Oil Black BY, Oil Black BS, Oil Black T-505 (all from Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247.

As a colorant, a pigment is preferably used.

As the pigment, a pigment such as a phthalocyanine-based pigment, an azo-based pigment, carbon black, or titanium oxide may suitably be used, and a phthalocyanine-based pigment is most preferably used.

It is preferable to add these colorants because the image area and the non-image area after image formation can be easily differentiated. The amount of colorant added is preferably 0.01 to 10 wt % relative to the total solids content of the photosensitive layer.

Other photosensitive layer components

The photosensitive layer may further contain various additives as necessary. As the additive, a surfactant for promoting developability and improving coated surface conditions, a hydrophilic polymer for improving developability and improving dispersion stability of microcapsules, a printing out agent for making visible an image area and a non-image area, a polymerization inhibitor for inhibiting unwanted thermal polymerization of a radically polymerizable compound during production or storage of a photosensitive layer, a higher fatty derivative for preventing polymerization inhibition by oxygen, inorganic particles for improving cured film strength of an image area, a hydrophilic low molecular weight compound for improving developability, a co-sensitizer or a chain transfer agent for improving sensitivity, a plasticizer for improving plasticity, etc. may be added. These compounds may employ known substances such as compounds described in, for example, JP-A-2007-171406, JP-A-2007-206216, JP-A-2007-206217, JP-A-2007-225701, JP-A-2007-225702, JP-A-2007-316582, and JP-A-2007-328243.

As a compound functioning as a chain transfer agent, a group of compounds having SH, PH, SiH, or GeH in the molecules may be used. These compounds can donate hydrogen to a low activity radical species to generate a radical or are oxidized and then deprotonated to generate a radical.

The photosensitive layer may preferably employ as a chain transfer agent a thiol compound (e.g. a 2-mercaptobenzimidazole, a 2-mercaptobenzothiazole, a 2-mercaptobenzoxazole, a 3-mercaptotriazole, a 5-mercaptotetrazole, etc.) in particular.

Among them, a thiol compound represented by Formula (S) below is particularly suitably used. In accordance with the use of a thiol compound represented by Formula (S) as a chain transfer agent, degradation of sensitivity due to evaporation from the photosensitive layer or diffusion to another layer can be avoided, the storage stability is excellent, and a lithographic printing plate precursor having high sensitivity and high plate life can be obtained.

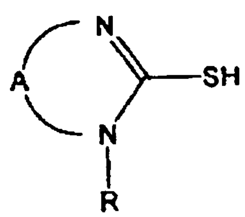

(S)

In Formula (S), R denotes an optionally substituted alkyl group or an optionally substituted aryl group, A denotes an atomic group forming together with the N=C-N moiety a carbon atom-containing 5- or 6-membered heterocycle, and A may further have a substituent.

Formation of Photosensitive Layer

The photosensitive layer is formed by dispersing or dissolving a binder polymer, an ethylenically unsaturated compound, a polymerization initiator, organically modified particles, and each of the above-mentioned necessary components in a solvent to prepare a coating liquid and applying the liquid.

As the solvent used here, there can be cited for example ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, *N,N*-dimethylacetamide, *N,N*-dimethylformamide, tetramethylurea, *N*-methylpyrrolidone, dimethylsulfoxide, sulfolane, γ-butyrolactone, toluene, and water, but the present invention should not be construed as being limited thereto.

These solvents may be used singly or as a mixture.

The solids content concentration of the coating liquid is preferably 1 to 50 wt %. The photosensitive layer may also be formed by preparing a plurality of coating liquids by dispersing or dissolving the same or different components described above in the same or different solvents and repeatedly coating and drying a plurality of times.

The amount (solids content) of the photosensitive layer that the support is coated with after coating and drying may be varied depending on the use, but normally it is preferably 0.3 to 3.0 g/$m^2$. In the above-mentioned range good

sensitivity and good film properties of the photosensitive layer can be obtained.

Various methods can be used for the coating. Examples of the method include bar coater coating, spin coating, spray coating, curtain coating, dip coating, air knife coating, blade coating, and roll coating.

Protective Layer

In the lithographic printing plate precursor that can be used in the present invention, a protective layer (oxygen-blocking layer) is preferably provided on the photosensitive layer in order to prevent diffusion and penetration of oxygen, which inhibits a polymerization reaction at the time of exposure.

The protective layer preferably has an oxygen permeability (A) at 25˚C under one atmosphere of $1.0 \leq (A) \leq 20$ (mL/m$^2$·day). When the oxygen permeability (A) is at least 1.0 (mL/m$^2$·day), an undesirable polymerization reaction can be suppressed during production and during storage before image exposure, and the occurrence of the problems of undesirable fogging or widening of image lines during image exposure can be suppressed. When the oxygen permeability (A) is not more than 20 (mL/m$^2$·day), the sensitivity is excellent. The oxygen permeability (A) is more preferably in the range of $1.5 \leq (A) \leq 12$ (mL/m$^2$·day), and yet more preferably in the range of $2.0 \leq (A) \leq 10.0$ (mL/m$^2$·day).

Apart from the above-mentioned oxygen permeability, as properties required of the protective layer it is desirable that the protective layer does not substantially hinder the transmission of light used for exposure, has excellent adhesion to the photosensitive layer, and can be easily removed during a development step after exposure. Protective layers have already been devised and described in detail in U.S. Pat. No. 3,458,311 and JP-B-55-49729.

As the material that can be used for the protective layer, for example, a water-soluble polymer compound with relatively good crystallinity is preferably used. Specifically, a water-soluble polymer such as polyvinyl alcohol (PVA), a vinyl alcohol/vinyl phthalate copolymer, a vinyl acetate/vinyl alcohol/vinyl phthalate copolymer, a vinyl acetate/crotonic acid copolymer, polyvinylpyrrolidone, an acidic cellulose, gelatin, gum Arabic, polyacrylic acid, or polyacrylamide can be cited. The water-soluble polymer compound may be used singly or as a mixture. Of these compounds, it is preferable to use polyvinyl alcohol as a main component since the best results can be obtained in fundamental properties such as oxygen-blocking properties and development removability.

The polyvinyl alcohol for use in the protective layer may be partially substituted with ester, ether or acetal as long as it contains unsubstituted vinyl alcohol units for achieving the necessary oxygen-blocking properties and water solubility. In the same way, part of the polyvinyl alcohol may have another copolymer component.

As specific examples of the polyvinyl alcohol, those with 71 to 100 mol % hydrolysis and 300 to 2,400 polymerization repeating units can be cited.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (Kuraray Co., Ltd.). They can be used singly or as a mixture. In a preferred embodiment, the polyvinyl alcohol content in the protective layer is 20 to 95 wt %, and more preferably 30 to 90 wt %.

Furthermore, a known modified polyvinyl alcohol may also be preferably used. For example, polyvinyl alcohols of various degrees of polymerization having at random various types of hydrophilic modified sites such as an anion-modified site modified with an anion such as a carboxy group or a sulfo group, a cation-modified site modified with a cation such as an amino group or an ammonium group, a silanol-modified site, and a thiol-modified site, and polyvinyl alcohols of various degrees of polymerization having at the terminal of the polymer chain various types of modified sites such as the above-mentioned anion-modified site, the above-mentioned cation-modified site, a silanol-modified site, and a thiol-modified site and, furthermore, an alkoxy-modified site, a sulfide-modified site, an ester-modified site of vinyl alcohol with various types of organic acids, an ester-modified site of the above-mentioned anion-modified site with an alcohol, and an epoxy-modified site can be cited.

As a component used as a mixture with polyvinyl alcohol, polyvinylpyrrolidone or a modified product thereof is preferable from the viewpoint of oxygen-blocking properties and development removability. The content thereof in the protective layer is preferably 3.5 to 80 wt %, more preferably 10 to 60 wt %, and yet more preferably 15 to 30 wt %.

The components of the protective layer (PVA selection and use of additives), the amount coated, etc. are determined taking into consideration fogging properties, adhesion, and scratch resistance in addition to oxygen-blocking properties and development removability. In general, the higher the degree of hydrolysis of the PVA used (the higher the unsubstituted vinyl alcohol unit content in the protective layer) and the thicker the film thickness, the higher are the oxygen-blocking properties, which is advantageous from the viewpoint of sensitivity.

The molecular weight of the (co)polymer of the above-mentioned polyvinyl alcohol (PVA), etc. is preferably 2,000 to 10,000,000 and more preferably 20,000 to 3,000,000.

As other components of the protective layer, glycerol, dipropylene glycol, etc. can be added in an amount corresponding to several wt % of the (co)polymer to impart flexibility. Furthermore, an anionic surfactant such as a sodium alkylsulfate or sodium alkylsulfonate; an amphoteric surfactant such as an alkylaminocarboxylic acid salt or an

alkylaminodicarboxylic acid salt; or a nonionic surfactant such as a polyoxyethylene alkyl phenyl ether can be added in an amount corresponding to several wt % of the (co)polymer.

Furthermore, adhesion to an image area and scratch resistance are also extremely important for handling of a plate. That is, when a hydrophilic layer comprising a water-soluble polymer is layered on an oleophilic photosensitive layer, layer peeling due to insufficient adhesion is liable to occur, and the peeled portion causes defects such as incomplete film curing due to polymerization inhibition by oxygen. Various proposals have been made for improving the adhesion between these two layers. For example, it is known that sufficient adhesion can be obtained by mixing from 20 to 60 wt % of an acrylic-based emulsion or a water-insoluble vinylpyrrolidone/vinyl acetate copolymer with a hydrophilic polymer mainly comprising polyvinyl alcohol and layering the resulting mixture on the photosensitive layer. Any of these known techniques may be applied to the protective layer according to the present invention. Coating methods for such a protective layer are described in detail, for example, in U.S. Pat. No. 3,458,311 and JP-B-55-49729.

Furthermore, it is also preferable for an inorganic layered compound to be contained in the protective layer of the lithographic printing plate precursor for the purpose of improving the oxygen-blocking properties and the photosensitive layer surface protection properties.

The inorganic layered compound used here is a particle having a thin tabular shape and includes, for example, mica, for example, natural mica represented by the following formula:

$$A(B,C)_{2\text{-}5}sD_4O_{10}(OH,F,O)_2$$

(in the formula A denotes any one of K, Na, and Ca, B and C denote any one of Fe (II), Fe(III), Mn, Al, Mg, and V, and D denotes Si or Al) or synthetic mica; talc represented by the following formula: $3MgO{\cdot}4SiO{\cdot}H_2O$; taeniolite; montmorillonite; saponite; hectorite; and zirconium phosphate.

Of the inorganic layered compounds, fluorine-based swellable synthetic mica, which is a synthetic inorganic layered compound, is particularly useful in the present invention.

The aspect ratio of the inorganic layered compound is preferably at least 20, more preferably at least 100, and yet more preferably at least 200. The aspect ratio is the ratio of thickness to major axis of a particle and can be determined, for example, from a projection drawing of a particle by microphotography. The larger the aspect ratio, the greater the effect obtained.

As for the particle size of the inorganic layered compound, the average major axis is preferably 0.3 to 20 μm, more preferably 0.5 to 10 μm, and yet more preferably 1 to 5 μm. The average thickness of the particle is preferably not more than 0.1 μm, more preferably not more than 0.05 μm, and yet more preferably not more than 0.01 μm. For example, in the swellable synthetic mica that is a representative compound of the inorganic layered compound, the thickness is preferably on the order of from 1 to 50 nm and the plane size is on the order of from 1 to 20 μm.

When such an inorganic layered compound particle having a large aspect ratio is contained in the protective layer, the coated film strength increases and, furthermore, since penetration of oxygen or moisture can be inhibited effectively deterioration of the protective layer due to deformation, etc. can be prevented, and even when the lithographic printing plate precursor is stored for a long period of time under high humidity conditions there is no degradation in the image-forming properties thereof due to change in humidity and the storage stability is excellent.

The content of the inorganic layered compound in the protective layer is preferably 5/1 to 1/00 as a ratio by weight relative to the amount of binder used in the protective layer. When a plurality of inorganic layered compounds are used in combination, it is also preferable that the total amount of the inorganic layered compounds is in the above-mentioned weight ratio range.

A method for dispersing the inorganic layered compound used in the protective layer may employ a method described in JP-A-2007-171406, JP-A-2007-206216, JP-A-2007-206217, JP-A-2007-225701, JP-A-2007-225702, JP-A-2007-316582, JP-A-2007-328243, etc.

The coating amount of the protective layer is preferably in the range of 0.05 to 10 $g/m^2$ as a coating amount after drying. When the protective layer contains the inorganic layered compound, it is more preferably in the range of 0.1 to 0.5 $g/m^2$, and when the protective layer does not contain the inorganic layered compound, it is more preferably in the range of 0.5 to 5 $g/m^2$.

Support

The support used for lithographic printing plate precursor is not particularly limited, and a dimensionally stable sheet-form hydrophilic support may be used. Examples of materials forming the support include paper, paper laminated with a plastic (e.g. polyethylene, polypropylene, polystyrene, etc.), a metal sheet (e.g. aluminum, zinc, copper, etc.), a plastic film (e.g. cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper or plastic film on which the above-mentioned metal is laminated or vapor-deposited. Preferred

examples of the support include a polyester film and aluminum sheet. Among these, aluminum sheet is particularly preferable since the dimensional stability is good and it is relatively inexpensive.

The aluminum sheet is a pure aluminum sheet, an alloy sheet containing aluminum as a main component and a small amount of a different element, or a thin film of aluminum or an aluminum alloy laminated with a plastic. Examples of the different element contained in the aluminum alloy include silicon, iron, manganese, copper, magnesium, chromium, zinc, bismuth, nickel, and titanium. The content of the different element in the alloy is preferably equal to or less than 10 wt %. In the present invention, a pure aluminum sheet is preferable, but since it is difficult to produce completely pure aluminum because of the refining technique, a trace amount of a different element may be contained. The composition of the aluminum sheet is not specified, and a known generally used material may be utilized as appropriate.

The support preferably has a thickness of 0.1 to 0.6 mm, more preferably 0.15 to 0.4 mm, and yet more preferably 0.2 to 0.3 mm.

Prior to the aluminum sheet being used, it is preferably subjected to a surface treatment such as a surface roughening treatment or an anodizing treatment. Surface treatment makes it easy to improve the hydrophilicity and ensure that there is good adhesion between a photosensitive layer and the support. Prior to the aluminum sheet being subjected to the surface roughening treatment, it may be subjected as desired to a degreasing treatment using a surfactant, an organic solvent, an aqueous alkaline solution, etc. in order to remove rolling oil on the surface.

The surface roughening treatment for the aluminum sheet surface may be carried out by various types of methods, and examples thereof include a mechanical surface roughening treatment, an electrochemical surface roughening treatment (a surface roughening treatment involving dissolving the surface electrochemically), and a chemical surface roughening treatment (a surface roughening treatment involving selectively dissolving the surface chemically).

As a method for the mechanical surface roughening treatment, a known method such as a ball grinding method, a brush grinding method, a blast grinding method, or a buff grinding method may be used.

As a method for the electrochemical surface roughening treatment, for example, a method in which alternating current or direct current is applied in an electrolyte solution containing an acid such as hydrochloric acid or nitric acid can be cited. It is also possible to employ a method as described in JP-A-54-63902 in which a mixed acid is used.

The aluminum sheet subjected to a surface roughening treatment is subjected as necessary to an alkali etching treatment using an aqueous solution of potassium hydroxide, sodium hydroxide, etc.; furthermore, after neutralization, it may be subjected to an anodizing treatment as desired in order to improve the abrasion resistance.

As an electrolyte that may be used for the anodizing treatment of the aluminum sheet, various types of electrolytes that form a porous oxide film may be used. In general, sulfuric acid, hydrochloric acid, oxalic acid, chromic acid, or a mixed acid thereof may be used. The concentration of the electrolyte may be determined as appropriate according to the type of electrolyte.

Conditions for the anodizing treatment depend on the type of electrolyte used and cannot be specified, but in general the electrolyte solution concentration is 1 to 80 wt %, the solution temperature is 5°C to 70°C, the current density is 5 to 60 A/dm$^2$, the voltage is 1 to 100V, and the electrolysis time is 10 sec. to 5 min. The amount of anodized film formed is preferably 1.0 to 5.0 g/m$^2$, and more preferably 1.5 to 4.0 g/m$^2$. In the above-mentioned range, good plate life and good scratch resistance of a non-image area of a lithographic printing plate can be obtained.

As the support that can be used in the present invention, a substrate that has been subjected to the above-mentioned surface treatment and has an anodized film may be used as it is, but in order to further improve the adhesion to the upper layer, and the hydrophilicity, the contamination resistance, thermal insulating properties etc., the substrate may appropriately be subjected as necessary to a treatment for enlarging micropores of the anodized film, a sealing treatment, or a surface hydrophilization treatment involving immersion in an aqueous solution containing a hydrophilic compound, which are described in JP-A-2001-253181 or JP-A-2001-322365. These enlarging and sealing treatments are not limited to those described therein, and any conventionally known methods may be employed.

The sealing treatment may be vapor sealing, a treatment with an aqueous solution containing an inorganic fluorine compound such as a single treatment with fluorozirconic acid or a treatment with sodium fluoride, vapor sealing with added lithium chloride, or a sealing treatment with hot water.

Among these, the sealing treatment with an aqueous solution containing an inorganic fluorine compound, the sealing treatment with vapor, and the sealing treatment with hot water are preferable.

With regard to a hydrophilization treatment, there is an alkali metal silicate method, as disclosed in U.S. Pat. Nos. 2,714,066, 3,181,461, 3,280,734, and 3,902,734. In this method, a support is immersed in an aqueous solution of sodium silicate, etc., or subjected to electrolysis. In addition, there is a method in which a support is treated with potassium fluorozirconate, as described in JP-B-36-22063, and a method in which a support is treated with polyvinylphosphonic acid, as described in U.S. Pat. Nos. 3,276,868, 4,153,461, and 4,689,272.

Furthermore, when a support having insufficient surface hydrophilicity such as a polyester film is used as a support, it is preferable to coat the surface with a hydrophilic layer so as to make the surface hydrophilic.

As the hydrophilic layer, a hydrophilic layer, described in JP-A-2001-199175, formed by coating with a coating liquid containing a colloid of an oxide or hydroxide of at least one element selected from the group consisting of beryllium,

magnesium, aluminum, silicon, titanium, boron, germanium, tin, zirconium, iron, vanadium, antimony, and a transition metal, a hydrophilic layer, described in JP-A-2002-79772, having an organic hydrophilic matrix obtained by crosslinking or pseudo-crosslinking an organic hydrophilic polymer, a hydrophilic layer having an inorganic hydrophilic matrix obtained by sol-gel exchange involving dehydration and condensation reactions of a polyalkoxysilane, titanate, zirconate or aluminate, or a hydrophilic layer formed from an organic thin film having a surface containing a metal oxide is preferable. Among them, a hydrophilic layer formed by coating with a coating liquid containing a colloid of an oxide or hydroxide of silicon is preferable.

Furthermore, when a polyester film, etc. is used as a support, it is preferable to provide an antistatic layer on a hydrophilic layer side, the opposite side, or both sides of the support. When an antistatic layer is provided between the support and a hydrophilic layer, it also contributes to an improvement in adhesion to the hydrophilic layer. As an antistatic layer, a polymer layer, described in JP-A-2002-79772, in which metal oxide microparticles or a matting agent are dispersed, etc. may be used.

The support preferably has a center line average roughness of 0.10 to 1.2 μm. In the above-mentioned range, good adhesion to the photosensitive layer, good plate life, and good stain resistance can be obtained.

Moreover, the color density of the support is preferably 0.15 to 0.65 as a reflection density value. In the above-mentioned range, it is possible to obtain good image formation properties by preventing halation during imagewise exposure and to obtain good ease of plate inspection after development.

Undercoat Layer

In the lithographic printing plate precursor, it is preferable to provide a known undercoat layer (hereinafter, also called an 'interlayer') above a support. In particular, an undercoat layer comprising a compound containing a polymerizable group is preferably provided. When an undercoat layer is used, the photosensitive layer is provided above the undercoat layer. The undercoat layer has the effects of strengthening adhesion between the support and the photosensitive layer in exposed areas and facilitating separation of the photosensitive layer from the support in unexposed areas, so that the developability and staining properties can be improved.

Specific preferred examples of the undercoat layer include a silane coupling agent having an addition-polymerizable ethylenic double bond reactive group described in JP-A-10-282679, and a phosphorus compound having an ethylenic double bond reactive group described in JP-A-2-304441. A particularly preferred compound is a compound having both a polymerizable group such as a methacrylic group or an allyl group and a support-adsorptive group such as a sulfonic acid group, a phosphoric acid group, or a phosphoric acid ester group. A compound having a hydrophilicity-imparting group such as an ethylene oxide group, in addition to the polymerizable group and the support-adsorptive group may also be cited as a preferable compound.

The coating amount (solids content) of the undercoat layer is preferably 0.1 to 100 $mg/m^2$, and more preferably 1 to 30 $mg/m^2$.

Backcoat layer

After applying a surface treatment to the support or forming the undercoat layer above the support, a backcoat layer may as necessary be provided on the back surface of the support.

As the backcoat layer, there can preferably be cited, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-35174. Among them, use of an alkoxy compound of silicon such as $Si(OCH_3)_4$, $Si(OC_2H_5)_4$, $Si(OC_3H_7)_4$, or $Si(OC_4H_9)_4$ is preferable since starting materials are inexpensive and readily available.

Developer

The developer for a lithographic printing plate (also called simply a 'developer') that can be used in the present invention has a pH of at least 2 but less than 11.

When a conventional lithographic printing plate precursor is developed using a developer having a pH of at least 2 but less than 11, compared with a case in which a conventional developer is used, it has been found that when a large amount of photosensitive layer containing particles (in particular, particles having a particle size of at least 1 nm but no greater than 100 nm) is developed, a residue containing the particles or a photosensitive layer component as a main component is deposited in the developer, and this adheres to a printing plate to thus cause printing stains or sticks to a processor, which becomes stained.

In contrast, developing the lithographic printing plate precursor used in the present invention using a developer having a pH of at least 2 but less than 11 enables deposition of the particles or other photosensitive layer components

as a residue to be suppressed, and the developability, staining properties, staining properties after aging, and plate life are improved; as a result a large amount of lithographic printing plate precursor can be processed with a small amount of developer.

Components forming the developer for a lithographic printing plate used in the present invention are explained below.

Water-soluble Polymer

The developer used in the present invention preferably contains a water-soluble polymer.

The developer used in the present invention more preferably contains carbonate ion, hydrogen carbonate ion, and a water-soluble polymer.

The water-soluble polymer that can be used in the developer used in the present invention includes, for example, soybean polysaccharide, modified starch, gum Arabic, dextrin, a cellulose derivative (for example, carboxymethylcellulose, carboxyethylcellulose, or methylcellulose) or a modified product thereof, pullulan, polyvinyl alcohol or a derivative thereof, polyvinylpyrrolidone, polyacrylamide, an acrylamide copolymer, a vinyl methyl ether/maleic anhydride copolymer, a vinyl acetate/maleic anhydride copolymer, a styrene/maleic anhydride copolymer, and polystyrenesulfonic acid.

As the soybean polysaccharide, known ones can be used. For example, as a commercial product, Soyafibe (trade name, Fuji Oil Co., Ltd.) is available, and various product grades can be used. The soybean polysaccharide preferably used has a viscosity in the range of 10 to 100 mPa/sec for a 10 wt % aqueous solution thereof.

As the modified starch, a known modified starch can be used. The modified starch can be prepared, for example, by a method wherein starch, for example, of corn, potato, tapioca, rice, or wheat is decomposed with, for example, an acid or an enzyme to the extent that the number of glucose residues per molecule is from 5 to 30 and then oxypropylene is added thereto in an alkali.

Two or more of the water-soluble polymers may be used in combination.

The content of the water-soluble polymer in the developer is preferably 0.1 to 20 wt %, and more preferably 0.5 to 10 wt %.

Other components

The developer that can be used in the present invention may comprise, in addition to the water-soluble polymer, an additive such as a surfactant, an organic solvent, a preservative, a chelating compound, an antifoaming agent, an organic acid, an inorganic acid, or a pH buffer agent as long as the effects of the present invention are not impaired.

Surfactant

The developer that can be used in the present invention preferably comprises a surfactant.

The surfactant that can be used in the present invention may comprise any of anionic, nonionic, cationic, and amphoteric surfactants.

Examples of the anionic surfactant include a fatty acid salt, an abietic acid salt, a hydroxyalkanesulfonic acid salt, an alkanesulfonic acid salt, a dialkylsulfosuccinic acid salt, a straight-chain alkylbenzenesulfonic acid salt, a branched alkylbenzenesulfonic acid salt, an alkylnaphthalenesulfonic acid salt, an alkylphenoxypolyoxyethylene propylsulfonic acid salt, a polyoxyethylene alkylsulfophenyl ether salt, sodium N-methyl-N-oleyltaurine, a disodium *N*-alkylsulfosuccinic acid monoamide, a petroleum sulfonic acid salt, sulfated castor oil, sulfated tallow oil, a sulfate ester of a fatty acid alkyl ester, an alkylsulfate ester, a polyoxyethylene alkyl ether sulfate ester, a fatty acid monoglyceride sulfate ester, a polyoxyethylene alkyl phenyl ether sulfate ester, a polyoxyethylene styrylphenyl ether sulfate ester, an alkylphosphate ester, a polyoxyethylene alkyl ether phosphate ester, a polyoxyethylene alkyl phenyl ether phosphate ester, a partially saponified styrenemaleic anhydride copolymer, a partially saponified olefin-maleic anhydride copolymer, a naphthalenesulfonic acid salt formalin condensate, an aromatic sulfonic acid salt, and an aromatic substituted polyoxyethylenesulfonic acid salt. Among them, a dialkylsulfosuccinic acid salt, an alkylsulfate ester, or an alkylnaphthalenesulfonic acid salt is particularly preferably used.

The cationic surfactant is not particularly limited, and a conventionally known cationic surfactant may be used. Examples thereof include an alkylamine salt, a quaternary ammonium salt, a polyoxyethylene alkylamine salt, and a polyethylene polyamine derivative.

Examples of the nonionic surfactant include a polyethylene glycol type higher alcohol ethylene oxide adduct, an alkylphenol ethylene oxide adduct, an aromatic compound polyethylene glycol adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of an oil or fat, a polypropylene glycol ethylene oxide adduct, a dimethylsiloxane-ethylene oxide block copolymer, a dimethylsiloxane-(propylene oxide-ethylene oxide) block copolymer, a polyhydric alcohol type glycerol fatty acid ester, a pentaerythritol fatty acid ester, sorbitol and sorbitan fatty acid esters, a sucrose fatty acid ester, a polyhydric alcohol alkyl ether, and an alkanolamine fatty acid amide.

In the present invention, a polyethylene glycol type higher alcohol ethylene oxide adduct, an aromatic compound polyethylene glycol adduct, a sorbitol and/or sorbitan fatty acid ester ethylene oxide adduct, a polypropylene glycol ethylene oxide adduct, a dimethylsiloxane-ethylene oxide block copolymer, a dimethylsiloxane-(propylene oxide-ethylene oxide) block copolymer, and a polyhydric alcohol fatty acid ester are preferable.

Furthermore, from the viewpoint of stable solubility in water and turbidity, for the nonionic surfactant the HLB (Hydrophile-Lipophile Balance) value is preferably at least 6, and more preferably at least 8. It is also possible to similarly use acetylene glycol type and acetylene alcohol type oxyethylene adduct, fluorine type, silicone type etc. surfactants.

The surfactant may be used on its own or in a combination.

The content of the surfactant in the developer is preferably 0.01 to 10 wt %, and more preferably 0.01 to 5 wt %.

As is well known in the surfactant field, an amphoteric surfactant is a compound having an anionic site and a cationic site in a single molecule, and includes amphoteric surfactants of the amino acid type, betaine type, amine oxide type, etc.

As the amphoteric surfactant that can be used in the developer that can be used in the present invention, a compound represented by Formula <1> below and a compound represented by Formula <2> below are preferable.

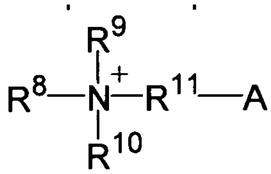

< 1 >

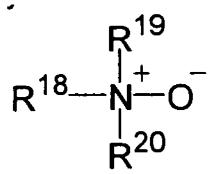

< 2 >

In Formula <1>, $R^8$ denotes an alkyl group, $R^9$ and $R^{10}$ independently denote a hydrogen atom or an alkyl group, $R^{11}$ denotes an alkylene group, and A denotes a carboxylate ion or a sulfonate ion.

In Formula <2>, $R^{18}$, $R^{19}$, and $R^{20}$ independently denote a hydrogen atom or an alkyl group, but not all of $R^{18}$, $R^{19}$, and $R^{20}$ are hydrogen atoms.

In Formula <1> above, the alkyl group denoted by $R^8$, $R^9$, or $R^{10}$ and the alkylene group denoted by $R^{11}$ may be straight chain or branched chain, may have a linking group in the chain, and may further have a substituent. As the linking group, one containing a hetero atom, such as an ester bond, an amide bond, or an ether bond is preferable. Furthermore, as the substituent a hydroxy group, an ethylene oxide group, a phenyl group, an amide group, a halogen atom, etc. are preferable.

In the compound represented by Formula <1>, the sum total of the carbon atoms of $R^8$ to $R^{11}$ is preferably 8 to 25, and more preferably 11 to 21. When in this range, a hydrophobic portion is appropriate, and the solubility in an aqueous developer is excellent.

Furthermore, by adding an organic solvent such as an alcohol as a dissolution adjuvant, the solubility of a surfactant in an aqueous developer can be improved.

In Formula <2> above, the alkyl group denoted by $R^{18}$, $R^{19}$, or $R^{20}$ may be straight chain or branched chain, may have a linking group in the chain, and may further have a substituent. As the linking group, one containing a hetero atom, such as an ester bond, an amide bond, or an ether bond is preferable. Furthermore, as the substituent a hydroxy group, an ethylene oxide group, a phenyl group, an amide group, a halogen atom, etc. are preferable.

In the compound represented by Formula <2>, the sum total of the carbon atoms of $R^{18}$ to $R^{20}$ is preferably 8 to 22, and more preferably 10 to 20. When in this range, a hydrophobic portion is appropriate, and the solubility in an aqueous developer is excellent.

The total number of carbon atoms of the amphoteric surfactant might be influenced by the properties of a material used in the photosensitive layer, in particular a binder. In the case of a highly hydrophilic binder, one in which the total number of carbon atoms is relatively small is preferable, and when the binder used has a low degree of hydrophilicity one in which the total number of carbon atoms is large tends to be preferable.

Preferred specific examples of the amphoteric surfactant that can be used in the developer that can be used in the present invention are listed below, but the present invention is not limited thereto.

W-1 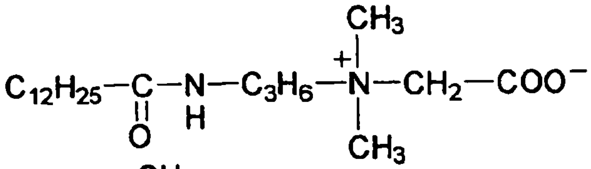

W-2 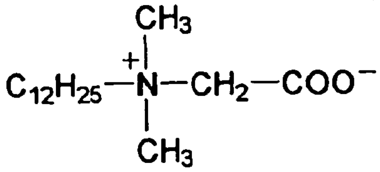

W-3 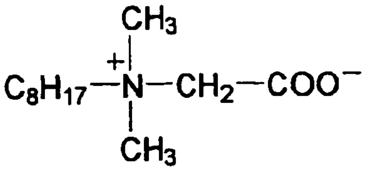

W-4 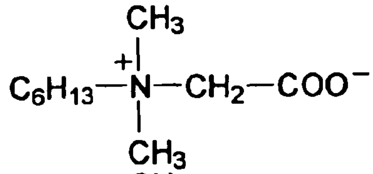

W-5 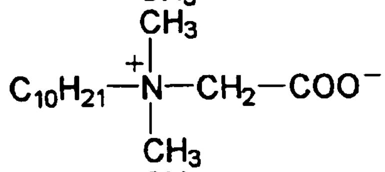

W-6 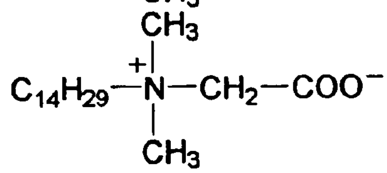

W-7 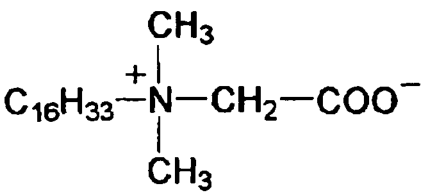

W-8 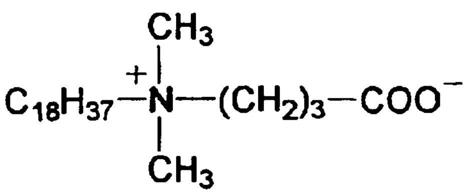

W-9 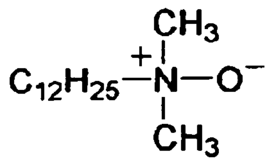

W-10 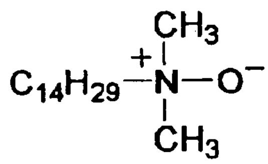

W-11 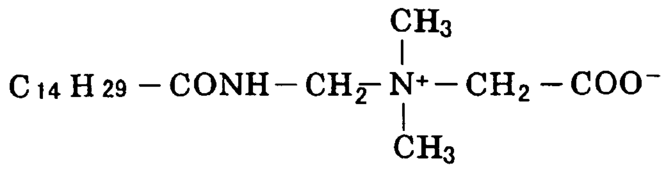

W-12 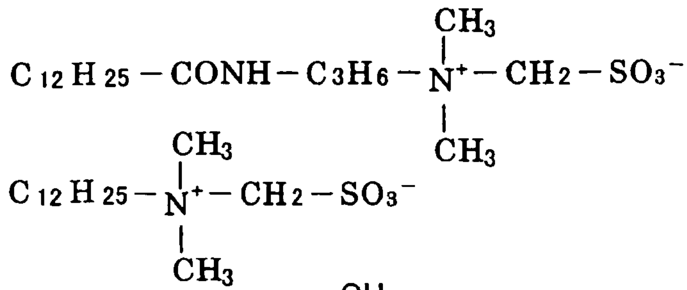

W-13

W-14 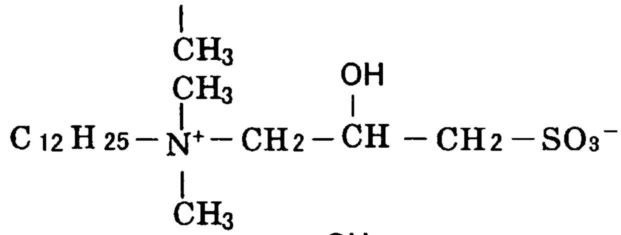

W-15 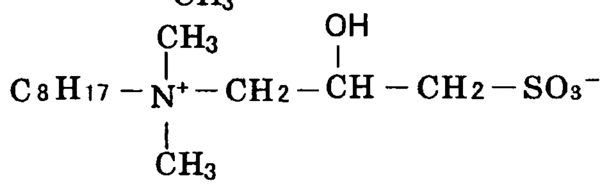

W-16 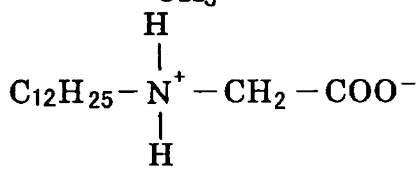

W-17 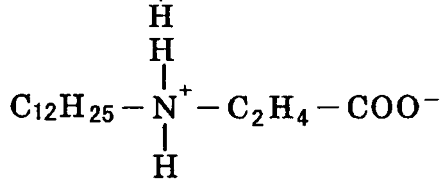

The surfactant may be used in a combination of two or more types. When two or more types are used as a mixture, the proportion of the surfactant that is added in the least amount is preferably at least 10 wt %, more preferably at least 20 wt %, and yet more preferably at least 30 wt %, relative to the total weight of surfactants mixed.

Furthermore, the total content of surfactants in the developer is preferably 0.01 to 20 wt %, and more preferably 0.1 to 10 wt %.

Organic solvent

The developer that can be used in the present invention may contain an organic solvent.

Examples of the organic solvent that can be contained in the developer include an aliphatic hydrocarbon (e.g. hexane, heptane, Isopar E, Isopar H, Isopar G (Esso Chemical Co., Ltd.), gasoline, or kerosene), an aromatic hydrocarbon (e.g. toluene or xylene), a halogenated hydrocarbon (methylene dichloride, ethylene dichloride, triclene, or monochlorobenzene), and a polar solvent.

Examples of the polar solvent include an alcohol (e.g. methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenylcarbinol, n-amyl alcohol, methylamyl alcohol, 1-butanol, 1-pentanol, 1-hexanol, 1-heptanol, 1-octanol, 2-octanol, 2-ethyl-1-hexanol, 1-nonanol, 1-decanol, ethylene glycol, diethylene glycol, ethylene glycol monomethyl ether, diethylene glycol monomethyl ether, propylene glycol, dipropylene glycol, propylene glycol mono-n-butyl ether, propylene glycol monophenylether, 3-ethoxy-1-propanol, or 3-phenoxy-1-propanol), a ketone (e.g. acetone, methyl ethyl ketone, ethyl butyl ketone, methyl isobutyl ketone, or cyclohexanone), an ester (e.g. ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, or butyl levulinate), and others (e.g. triethyl phosphate, tricresyl phosphate, *N*-phenylethanolamine, or *N*-phenyldiethanolamine).

Furthermore, from the viewpoint of developability, an organic amine compound can be cited as a preferred mode of the organic solvent contained in the developer. Specific examples of the organic amine compound include triethylamine, tributylamine, those described as specific examples of the organic alkali agent, and those described as specific examples of the water-soluble amine compound.

From the viewpoint of developability and volatility (odor), the organic amine compound contained in the developer is particularly preferably a compound simultaneously having an N atom and an O atom, such as 2-aminoethanol, 2-(2-aminoethoxy)ethanol, *N*-phenylethanolamine, *N*-phenyldiethanolamine, *N*-methyldiethanolamine, *N*-ethyldiethanolamine, 4-(2-aminoethyl)morpholine, *N*-(3-aminopropyl)diethanolamine, 4-(2-hydroxyethyl)morpholine, 1-piperazineethanol, 1-piperidineethanol, diethanolamine, triethanolamine, 4-(3-hydroxypropyl)morpholine, 3-morpholinopropylamine, 4-(2-hydroxypropyl)morpholine, or 3-morpholino-1,2-propanediol.

Furthermore, when the organic solvent is insoluble in water, it may be employed by being solubilized in water using a surfactant or the like. In the case where the developer contains an organic solvent, the concentration of the organic solvent is preferably less than 40 wt % from the viewpoint of safety and inflammability.

Preservative

As the preservative, for example, phenol or a derivative thereof, formalin, an imidazole derivative, sodium dehydroacetate, a 4-isothiazolin-3-one derivative, benzisothiazolin-3-one, a benzotriazole derivative, an amidine guanidine derivative, a quaternary ammonium salt, a pyridine derivative, a quinoline derivative, a guanidine derivative, a diazine, a triazole derivative, an oxazole, an oxazine derivative, or a nitrobromoalcohol such as 2-bromo-2-nitropropane-1,3-diol, 1,1-dibromo-1-nitro-2-ethanol, or 1,1-dibromo-1-nitro-2-propanol is preferably used.

Two or more types of preservatives may be used in combination.

The content of the preservative in the developer is preferably 0.01 to 10 wt %, and more preferably 0.05 to 5 wt %.

Chelating compound

As the chelating compound, for example, ethylenediaminetetraacetic acid, the potassium salt thereof, or the sodium salt thereof; diethylenetriaminepentaacetic acid, the potassium salt thereof, or the sodium salt thereof; triethylenetetraminehexaacetic acid, the potassium salt thereof, or the sodium salt thereof; hydroxyethylethylenediaminetriacetic acid, the potassium salt thereof, or the sodium salt thereof; nitrilotriacetic acid or the sodium salt thereof; an organic phosphonic acid, for example, 1-hydroxyethane-1,1-diphosphonic acid, the potassium salt thereof, or the sodium salt thereof; or aminotri(methylenephosphonic acid), the potassium salt thereof, or the sodium salt thereof; or a phosphonoalkanetricarboxylic acid can be cited. Instead of the sodium salt or potassium salt of the chelating compound an organic amine salt is also effective.

Two or more types of chelating compounds may be used in combination.

The content of the chelating compound in the developer is preferably 0.01 to 10 wt %, and more preferably 0.05 to 5 wt %.

Antifoaming agent

As the antifoaming agent a normal silicone-based self-emulsifying type or emulsifying type, or nonionic surfactant etc. compound having an HLB of 5 or less may be used. Among these, a silicone antifoaming agent is preferable.

Any of emulsifying dispersing type and solubilizing type antifoaming agents may be used.

Two or more types of antifoaming agents may be used in combination.

The content of the antifoaming agent in the developer is preferably 0.01 to 10 wt %, and more preferably 0.05 to 5 wt %.

Organic acid

As the organic acid, for example, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, and an organic phosphonic acid can be cited. The organic acid may also be used in the form of an alkali metal salt or an ammonium salt thereof.

Inorganic acid

As the inorganic acid and inorganic acid salt, for example, phosphoric acid, metaphosphoric acid, monoammonium phosphate, diammonium phosphate, monosodium phosphate, disodium phosphate, monopotassium phosphate, dipotassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, and nickel sulfate can be cited.
The organic acid and/or the inorganic acid may be used in a combination of two or more types.
The total content of the organic acid and the inorganic acid in the developer is preferably 0.01 to 20 wt %, and more preferably 0.05 to 10 wt %.

pH buffer agent

The developer that can be used in the present invention preferably contains a pH buffer agent.
The pH buffer agent is not particularly limited as long as it is a buffer agent exhibiting a buffering action at a pH of at least 2 but less than 11.
Examples of the pH buffer agent include (a) carbonate ion and hydrogen carbonate ion, (b) borate ion, (c) a water-soluble amine compound and an ion of the amine compound, and the combined use thereof. That is, for example, (a) a combination of carbonate ion-hydrogen carbonate ion, (b) borate ion, or (c) a combination of water-soluble amine compound-ion of the amine compound is preferable since it exhibits a pH buffering action in the developer, can suppress change in pH when the developer is used for a long period of time, and can suppress degradation of developability, the occurrence of development residue, etc. due to change in pH. Furthermore, a combination of carbonate ion and hydrogen carbonate ion is particularly preferable.
In order to make (a) carbonate ion and hydrogen carbonate ion present in the developer, a carbonate salt and a hydrogen carbonate salt may be added to the developer, or carbonate ion and hydrogen carbonate ion may be formed by adjusting the pH after a carbonate salt or a hydrogen carbonate salt is added.
The carbonate salt and the hydrogen carbonate salt are not particularly limited, but an alkali metal salt is preferable. As the alkali metal, lithium, sodium, and potassium can be cited, and sodium is particularly preferable. They may be used singly or in a combination of two or more types.
In order to make (b) borate ion present in the developer, after boric acid or a boric acid salt is added to the developer, the pH is adjusted using an alkali or an alkali and an acid, thus forming an appropriate amount of borate ion.
The boric acid or the boric acid salt used here is not particularly limited; examples of the boric acid include orthoboric acid, metaboric acid, and tetraboric acid, and among them orthoboric acid and tetraboric acid are preferable. Furthermore, examples of the boric acid salt include an alkali metal salt and an alkaline earth metal salt; an orthoboric acid salt, a diboric acid salt, a metaboric acid salt, a tetraboric acid salt, a pentaboric acid salt, and an octaboric acid salt can be cited, and among them an orthoboric acid salt and a tetraboric acid salt, in particular an alkali metal tetraboric acid salt, are preferable. Preferred examples of the tetraboric acid salt include sodium tetraborate, potassium tetraborate, and lithium tetraborate, and among them sodium tetraborate is preferable. Two or more types of boric acid salts may be used in combination.
As the boric acid or boric acid salt that can be used in the present invention, orthoboric acid, tetraboric acid, or sodium tetraborate is particularly preferable. The developer may use boric acid and a boric acid salt in combination.
The ion of the water-soluble amine compound (c) may be generated in an aqueous solution of the water-soluble amine compound; an alkali or an acid may further be added to the aqueous solution of the water-soluble amine compound, or it may be made present in an aqueous solution by adding a compound that is itself a salt of the amine compound.
The water-soluble amine compound is not particularly limited, but is preferably a water-soluble amine compound having a group that promotes water solubility. Examples of the group that promotes water solubility include a carboxylic acid group, a sulfonic acid group, a sulfinic acid group, a phosphonic acid group, and a hydroxy group. The water-soluble amine compound may contain a plurality of these groups in combination. Furthermore, the group that promotes water solubility is preferably a carboxylic acid group, a sulfonic acid group, or a hydroxy group, and most preferably a hydroxy group.
When the water solubility of an amine compound is promoted by a carboxylic acid group, a sulfonic acid group, a sulfinic acid group, or a phosphonic acid group, it corresponds to an amino acid. An amino acid is in equilibrium in an aqueous solution, and when the acid group is for example a carboxylic acid group, the equilibrium can be expressed as shown below. The amino acid referred to in the present invention means state B below, and the ion of an amino acid referred to means state C. As a counterion in state C, sodium ion or potassium ion is preferable. The state B below need not be a zwitterionic state and may be a state in which the amino and carboxy groups are uncharged.

Equilibrium of amino acid (when acid group is carboxylic acid)

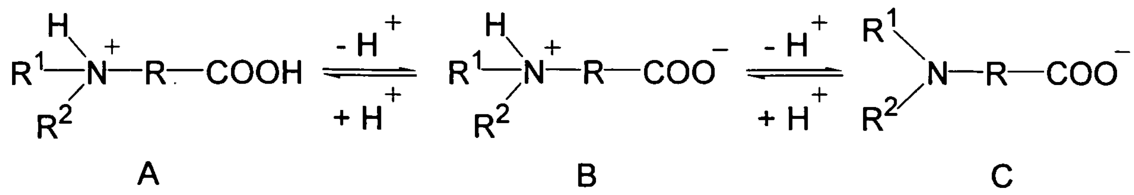

(For example, $R^1$ and $R^2$ independently denote a hydrogen atom, an alkyl group, an aryl group, etc., and R denotes a linking group.)

Specific examples of the water-soluble amine compound having a carboxylic acid group, a sulfonic acid group, or a sulfinic acid group include amino acids such as glycine, iminodiacetic acid, lysine, threonine, serine, aspartic acid, parahydroxyphenylglycine, dihydroxyethylglycine, alanine, anthranilic acid, and tryptophan, sulfamic acid, fatty acid aminesulfonic acids such as cyclohexylsulfamic acid and taurine, and fatty acid aminesulfinic acids such as aminoethanesulfinic acid. Among them, glycine and iminodiacetic acid are preferable.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid, and ethylenediaminopentamethylenephosphonic acid. 2-Aminoethylphosphonic acid is particularly preferable.

The water-soluble amine compound having a hydroxy group as the group promoting water solubility means an alkylamine having a hydroxy group on the alkyl group (state B' below), and an ion thereof means an ammonium ion of the amino group (state A' below).

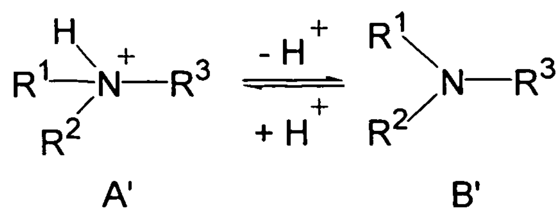

(For example, $R^1$, $R^2$, and $R^3$ independently denote a hydrogen atom, an alkyl group, an aryl group, etc. At least one of $R^1$, $R^2$, and $R^3$ is an alkyl group having a hydroxy group.)

Specific examples of the water-soluble amine compound having a hydroxy group include monoethanolamine, diethanolamine, trimethanolamine, triethanolamine, monoisopropanolamine, diisopropanolamine, tripropanolamine, triisopropanolamine, and 4-(2-hydroxyethyl)morpholine. Among them, triethanolamine, diethanolamine, and 4-(2-hydroxyethyl)morpholine are preferable. Examples of the ammonium ion counterion include a halide ion such as chloride ion or bromide ion, an anion of a mineral acid such as sulfuric acid or nitric acid, an anion of a carboxylic acid such as acetic acid, propionic acid, or benzoic acid, and an anion of a sulfonic acid such as methanesulfonic acid, ethanesulfonic acid, *p*-toluenesulfonic acid, or trifluoromethanesulfonic acid.

When as the pH buffer agent the combination (a) carbonate ion and hydrogen carbonate ion is used, the total amount of carbonate ion and hydrogen carbonate ion is preferably 0.05 to 5 mol/L relative to the total amount of developer, more preferably 0.1 to 2 mol/L, and particularly preferably 0.2 to 1 mol/L. When the total amount is at least 0.05 mol/L the developability and processing capacity do not deteriorate, and when it is no greater than 5 mol/L there is hardly any formation of a precipitate or crystals, there is hardly any gelling when carrying out neutralization during effluent treatment for the developer, and effluent treatment can be carried out without problems.

Furthermore, for the purpose of finely adjusting the alkali concentration or assisting dissolution of non-image area photosensitive layer, an alkali agent, for example, an organic alkali agent, may be added supplementarily.

Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkali agents may be used singly or in a combination of two or more types.

When (b) borate ion is used as the pH buffer agent, the total amount of borate ion is preferably 0.05 to 5 mol/L relative to the total amount of developer, more preferably 0.1 to 2 mol/L, and particularly preferably 0.2 to 1 mol/L. When the total amount of boric acid salt is at least 0.05 mol/L, the developability and processing capacity do not deteriorate, and when it is no greater than 5 mol/L there is hardly any formation of a precipitate or crystals, there is hardly any gelling when carrying out neutralization during effluent processing for the developer, and effluent processing can be carried out without problems.

When (c) the water-soluble amine compound and an ion of the amine compound are used as the pH buffer agent, the total amount of the water-soluble amine compound and the ion of the amine compound is preferably 0.01 to 1 mol/L relative to the total amount of aqueous solution; when the total amount of the water-soluble amine compound and the ion of the amine compound is in this range the developability and processing capacity do not deteriorate, and the effluent processing is easy. It is more preferably in the range of 0.03 to 0.7 mol/L, and particularly preferably in the range of 0.05 to 0.5 mol/L.

The developer that can be used in the present invention can suitably be used as a developer and a developer replenisher for an exposed lithographic printing plate precursor, and it is preferably applied to an automatic processor that is described below.

In the case of conducting development processing using an automatic processor, the developer becomes exhausted in accordance with the amount processed, and hence the processing capacity may be restored using a replenisher or fresh developer. Furthermore, since the concentration of the developer changes due to evaporation of water, water may be replenished as appropriate. Such replenishment systems can be preferably applied to the plate-making process of the lithographic printing plate precursor according to the present invention.

<u>Process for making lithographic printing plate</u>

The process for making a lithographic printing plate of the present invention comprises an exposure step of imagewise exposing a lithographic printing plate precursor that comprises, above a hydrophilic support, a photosensitive layer comprising a binder polymer, an ethylenically unsaturated compound, a polymerization initiator, and organically modified particles (A) having a particle size of at least 1 nm but no greater than 100 nm, and a development processing step of carrying out development processing by one type of processing liquid having a pH of at least 2 but less than 11.

Furthermore, the process for making a lithographic printing plate of the present invention preferably comprises an exposure step of imagewise exposing by means of a laser a lithographic printing plate precursor that comprises, above a hydrophilic support, a photosensitive layer comprising at least a binder polymer, an ethylenically unsaturated compound, a polymerization initiator, and organically modified particles, and a development processing step of removing the photosensitive layer of a non-exposed portion in the presence of a developer having a pH of 2 to 11.

Furthermore, with regard to the process for making a lithographic printing plate of the present invention, the development processing step is preferably a step in which development processing and a gumming treatment are carried out using a single liquid, and is particularly preferably a step in which removal of the protective layer, development processing, and a gumming treatment are carried out using a single liquid.

Moreover, with regard to the process for making a lithographic printing plate of the present invention, it is preferable not to carry out a water-washing step either prior to or subsequent to the development processing step.

The process for making a lithographic printing plate of the present invention is a process for producing a lithographic printing plate by imagewise exposing and developing a lithographic printing plate precursor as described above.

As conventional developing processes, there can be cited (1) a method in which development is carried out using a strong alkali developer (pH at least 11), (2) a method in which development is carried out using a developer having a pH of at least 2 but less than 11, and (3) a method in which development is carried out on a printing machine while adding dampening water and/or ink (on-machine development).

In the present invention, a method in which development is carried out using a developer having a pH of at least 2 but less than 11 is employed.

In accordance with the process for making a lithographic printing plate of the present invention, immediately after the protective layer and the photosensitive layer of non-exposed portions are removed together using the developer having a pH of at least 2 but less than 11, the lithographic printing plate precursor can be set on a printing machine, and printing may be carried out.

On the other hand, the conventional development step (1) above employing the strong alkali developer requires a plurality of steps in which the protective layer is removed by a water washing pre-step, alkali development is then carried out, the alkali is removed by a water washing post-step, a gumming treatment is carried out by a gumming step, and drying is carried out by a drying step.

In the present invention, 'gumming' means a plate surface hydrophilizing treatment by a surfactant and/or a water-soluble polymer compound.

Furthermore, in the present invention, it is preferable for the developer to comprise a water-soluble polymer compound, and removal of protective layer-development-gumming steps are preferably carried out using a single developer.

In the process for making a lithographic printing plate of the present invention, a water washing post-step is not particularly required, and it is preferable that, after development and gumming are carried out using a single liquid, a drying step is carried out. Furthermore, a water washing pre-step is not particularly required, and it is preferable that removal of the protective layer is carried out at the same time as development and gumming. Moreover, it is preferable that, subsequent to development and gumming, surplus developer is removed using a squeegee roller, and drying is then carried out. Development of a lithographic printing plate precursor in the present invention may be carried out in accordance with a standard method, preferably at 0˚C to 60˚C, and more preferably at on the order of 15˚C to 40˚C, such as, for example, a method in which an exposed photosensitive lithographic printing plate precursor is immersed in a developer and rubbed by a brush or a method in which an exposed photosensitive lithographic printing plate precursor is sprayed with a developer and rubbed by a brush.

Furthermore, processing by such an automatic processor is advantageous from the viewpoint of being free from measures against development residue resulting from the protective layer and photosensitive layer encountered in the case of on-machine development.

Development processing using the developer having a pH of at least 2 but less than 11 in the present invention is preferably carried out by an automatic processor equipped with supply means for the developer and a rubbing member.

As the automatic processor there can be cited an automatic processor described in JP-A-2-220061 and JP-A-60-59351 in which a lithographic printing plate precursor after imagewise recording is subjected to a rubbing treatment while being transported, and an automatic processor described in U.S. Pat. Nos. 5,148,746 and 5,568,768 and GB Patent No. 2,297,719 in which a lithographic printing plate precursor after imagewise recording is placed on a cylinder and subjected to a rubbing treatment while rotating the cylinder. Among them, an automatic processor using a rotating brush roller as the rubbing member is particularly preferable.

The rotating brush roller may be appropriately selected by taking account, for example, of the scratch resistance of the image area and the robustness of the support of the lithographic printing plate precursor.

As the rotating brush roller, a known rotating brush roller produced by implanting a brush material in a plastic or metal roller may be used. For example, a rotating brush roller described in JP-A-58-159533 and JP-A-3-100554, or a brush roller described in JU-B-62-167253 (JU-B denotes a Japanese examined utility model application publication), in which a metal or plastic groove-shaped member having implanted in rows therein a brush material is closely radially wrapped around a plastic or metal roller acting as a core, may be used.

As the brush material, a plastic fiber (for example, a polyester-based synthetic fiber such as polyethylene terephthalate or polybutylene terephthalate; a polyamide-based synthetic fiber such as nylon 6,6 or nylon 6,10; a polyacrylic synthetic fiber such as polyacrylonitrile or a polyalkyl (meth)acrylate; or a polyolefin-based synthetic fiber such as polypropylene or polystyrene) may be used. For example, a brush material having a fiber bristle diameter of 20 to 400 $\mu$m and a bristle length of 5 to 30 mm may preferably be used.

The outer diameter of the rotating brush roller is preferably 30 to 200 mm, and the peripheral speed at the tip of the brush rubbing the plate surface is preferably 0.1 to 5 m/sec.

Furthermore, it is preferable to use a plurality, that is, two or more, rotating brush rollers.

The direction of rotation of the rotating brush roller may be the same direction or the opposite direction with respect to the transport direction of the lithographic printing plate precursor, but when two or more rotating brush rollers are used in an automatic processor as shown in FIG. 1, it is preferable that at least one rotating brush roller rotates in the same direction and at least one rotating brush roller rotates in the opposite direction. By such an arrangement, the photosensitive layer in the non-image area can be more reliably removed. Furthermore, rocking the rotating brush roller in the rotational axis direction of the brush roller is also effective.

In the removal step, the temperature of the developer of the present invention when used for removal of a photosensitive layer of a non-exposed portion, that is, development, may be any temperature, but is preferably 10˚C to 50˚C.

After the removal step is carried out, the developer may be dried by natural drying, but it is preferable to provide a drying step employing hot air, etc.

In the present invention, the lithographic printing plate after the rubbing treatment may if desired be subsequently subjected to water washing, a drying treatment, and a de-oleophilization treatment. In the de-oleophilization treatment, a known de-oleophilization liquid may be used.

Furthermore, in the process for making a lithographic printing plate of the present invention, the entire surface of the lithographic printing plate precursor may as necessary be heated before or during exposure or between exposure and development. By heating, an image-forming reaction in the photosensitive layer is accelerated and advantages in terms of, for example, improvement in sensitivity and plate life and stabilization of sensitivity are achieved. For the purpose of increasing image strength and plate life, it is also effective to carry out overall post-heating or overall exposure

of the image after development. Heating before development is usually preferably carried out under mild conditions of no greater than 150˚C. When the temperature is in this range, the problem of undesirable fogging occurring in non-image areas can be suppressed. Heating after development can be carried out using very severe conditions. The post-development heating temperature is preferably in the range of 100˚C to 500˚C. When in this range, a sufficient effect in strengthening the image is obtained, and the problems of deterioration of the support and thermal decomposition of image areas can be suppressed.

Prior to the removal step, the lithographic printing plate precursor is laser-exposed through a transparent original having a line image, a halftone dot image, etc., or imagewise exposed, for example, by laser beam scanning based on digital data.

A preferred wavelength of a light source is 350 nm to 450 nm or 700 nm to 1,200 nm. When it is 350 nm to 450 nm a lithographic printing plate precursor having a photosensitive layer containing a sensitizing dye having an absorption maximum in this region is used, and when it is 700 nm to 1,200 nm a lithographic printing plate precursor comprising an IR absorber, which is a sensitizing dye having an absorption maximum in this region, is used.

As a light source for 350 nm to 450 nm, a semiconductor laser is suitable.

As a light source for 700 nm to 1,200 nm, a solid laser or semiconductor laser emitting IR rays is suitable.

The exposure mechanism may be any of an internal drum system, an external drum system, a flatbed system, etc.

## Examples

The present invention is explained below by way of Examples, but the present invention should not be construed as being limited thereto.

### Synthesis of organically modified particles

### Synthetic example 1 (organically modified particles A-1)

A 1 L three-necked flask was charged with 300 g of PL-1-IPA (Fuso Chemical Co., Ltd., 2-propanol dispersion of silica particles, particle size 10 to 15 nm, silica concentration 12.5%), 30 g of acetic acid, 0.07 g of 4-methoxyphenol, and 8.79 g of 3-trimethoxysilylpropyl acrylate as a coupling agent, and heated and refluxed for 3 hours. Subsequently, 2-propanol was added thereto, thus giving organically modified particles whose solids content had been adjusted to 10 weight %.

Other organically modified particles were also synthesized by variously changing the type and amount added of particle dispersion and the type and amount added of coupling agent used in Synthetic Example 1. They are shown in Table 1.

(Table 1)

| Component (A) organically modified particles | Particles used | Particle size of particles (nm) | Coupling agent for organic modification | Equivalents of coupling agent (mmol) per g of particles |
|---|---|---|---|---|
| A-1 | PL-1-IPA (Fuso Chemical Co., Ltd.) | 10-15 | 3-Trimethooylsilylpropyl acrylate | 1.0 |
| A-2 | PL-1-IPA (Fuso Chemical Co., Ltd.) | 10-15 | *n*-Hexyltrimethoxysilane | 1.0 |
| A-3 | PL-2L-PGME (Fuso Chemical Co., Ltd.) | 15-20 | 3-Trimethoxylsilylpropyl methacrylate | 1.5 |
| A-4 | PL-2L-MEK (Fuso Chemical Co., Ltd.) | 15-20 | *n*-Octyltrimethoxysilane/ 3-trimethoxylsilylpropyl acrylate 50/50 molar ratio | 2.0 |
| A-5 | IPA-ST (Nissan Chemical Industries Ltd.) | 10-20 | 3-Trimethoxylsilylpropyl acrylate | 1.0 |

(continued)

| Component (A) organically modified particles | Particles used | Particle size of particles (nm) | Coupling agent for organic modification | Equivalents of coupling agent (mmol) per g of particles |
|---|---|---|---|---|
| A-6 | IPA-ST-UP (Nissan Chemical Industries Ltd.) | 40-100 | 3-Trimethoxylsilylpropyl methacrylate | 1.0 |
| A-7 | MEK-ST (Nissan Chemical Industries Ltd.) | 10-20 | 3-Trimethoxylsilylpropyl acrylate | 1.0 |
| A-8 | PGM-ST (Nissan Chemical Industries Ltd.) | 10-20 | 3-Trimethoxylsilyipropyl acrylate | 1.0 |
| A-9 | Desolite Z-7501 (JSR) | 10 | - | - |
| A-10 | Alumina Sol-10D (Kawaken Fine Chemicals Co., Ltd.) | 50-100 | 3-Trimethoxylsilylpropyl acrylate | 2.0 |
| A-11 | PL-1-IPA (Fuso Chemical Co., Ltd.) | 10-15 | 3-Trimethoxylsilylpropyl acrylate | 0.5 |
| A-12 | PL-1-IPA (Fuso Chemical Co., Ltd.) | 10-15 | 3-Trimethoxylsilylpropyl acrylate | 3.0 |

* : Desolite Z-7501 is an organically modified silica particle having acryloyl groups on the surface thereof.

Preparation of Support

A 0.3 mm thick aluminum plate (material: 1050) was subjected to a degreasing treatment with a 10 weight % aqueous solution of sodium aluminate at 50˚C for 30 sec in order to remove rolling oil on the surface thereof. Thereafter, the aluminum plate surface was grained using three nylon brushes implanted with bundled bristles having a diameter of 0.3 mm and an aqueous suspension (specific gravity: 1.1 g/cm$^3$) of pumice having a median diameter of 25 μm and then washed well with water. The plate was etched by immersing it in a 25 weight % aqueous solution of sodium hydroxide at 45˚C for 9 sec and, after washing with water, was immersed in 20 weight % aqueous solution of nitric acid at 60˚C for 20 sec, followed by washing with water. The amount of etching of the grained surface was about 3 g/m$^2$.

Subsequently, the aluminum plate was subjected to a consecutive electrochemical surface roughening treatment using an AC voltage of 60 Hz. An electrolytic liquid used here was a 1 weight % aqueous solution of nitric acid (containing 0.5 weight % of aluminum ion) at a liquid temperature of 50˚C. The electrochemical surface roughening treatment was carried out using as an AC power source waveform a trapezoidal rectangular wave alternating current having a duty ratio of 1:1 and a time TP from zero to peak current value of 0.8 msec, with a carbon electrode as the counter electrode. Ferrite was used as an auxiliary anode. The current density was 30 A/dm$^2$ as a peak current value, and 5% of the current flowing from the power source was diverted to the auxiliary anode.

The quantity of electricity in the nitric acid electrolysis was 175 C/dm$^2$ when the aluminum plate was the anode. Following this, washing with water was carried out by means of a spray.

Subsequently, the aluminum plate was subjected to an electrochemical surface roughening treatment in the same manner as in the nitric acid electrolysis above using, as an electrolytic liquid, a 0.5 weight % aqueous solution of hydrochloric acid (containing 0.5 weight % of aluminum ion) at a liquid temperature of 50˚C under conditions of a quantity of electricity of 50 C/dm$^2$ when the aluminum plate was the anode, and was then washed with water by spraying. The plate was then treated in a 15 weight % aqueous solution of sulfuric acid (containing 0.5 weight % of aluminum ion) as an electrolytic liquid at a current density of 15 A/dm$^2$ to provide a direct current anodic oxide film of 2.5 g/m$^2$, then washed with water, and dried.

The center line average roughness Ra (JIS B0601) of the surface of the support thus obtained was measured using a stylus having a diameter of 2 μm and found to be 0.51 μm.

Formation of middle layer

The support above was coated using a bar with middle layer coating liquid (1) having the formulation below and then dried in an oven at 80°C for 10 sec, thus forming a middle layer with a dry coat weight of 10 mg/$m^2$.

Middle layer coating liquid (1)

| | |
|---|---|
| Undercoat polymer (1) below | 0.017 g |
| Methanol | 9.00 g |
| Water | 1.00 g |

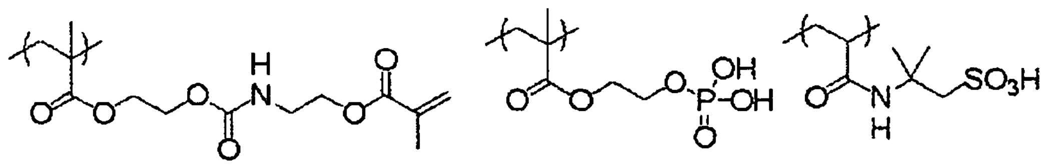

Undercoat polymer (1) (formulation ratio (mol %): from the left 5/15/80, molecular weight: 80,000)

Preparation of lithographic printing plate precursors 1 to 10 and comparative lithographic printing plate precursors 1 and 2

Formation of photosensitive layer and protective layer

The middle layer was coated with photosensitive layer coating liquid (1) having the formulation below using a bar and dried in an oven at 70°C for 60 sec to form a photosensitive layer having a dry coat weight of 1.1 g/$m^2$. Onto the photosensitive layer, protective layer coating liquid (1) having the formulation below was applied using a bar so as to give a dry coat weight of 0.75 g/$m^2$ and dried at 125°C for 70 sec to form a protective layer, thus giving lithographic printing plate precursor (1).

Photosensitive layer coating liquids (2) to (10) and comparative photosensitive layer coating liquids (1) and (2) were prepared in the same manner as for photosensitive layer coating liquid (1) except that the materials used were changed as described in Table 2 below, thus giving lithographic printing plate precursors 2 to 10 and comparative lithographic printing plate precursors 1 and 2.

Photosensitive Layer Coating Liquid (1)

| | |
|---|---|
| Binder polymer (1) below (average molecular weight: 80,000, acid value: 0 meq/g) | 0.48 g |
| Polymerizable compound (1) below | 0.54 g |
| Sensitizing dye (1) below | 0.06 g |
| Polymerization initiator (1) below | 0.08 g |
| Co-sensitizer (1) below | 0.07 g |
| ε-Phthalocyanine pigment dispersion | 0.40 g |
| (pigment: 15 parts by weight, dispersant binder polymer (1): 10 parts by weight, solvent: cyclohexanone/ methoxypropyl acetate/1-methoxy-2-propanol = 15 parts by weight/20 parts by weight/40 parts by weight) | |
| Thermal polymerization inhibitor | 0.01 g |
| (N-Nitrosophenylhydroxylamine aluminum salt) | |
| Fluorine-based surfactant (1) below (Mw = 11,000) | 0.001 g |
| Polyoxyethylene-polyoxypropylene condensate | 0.04 g |
| (Pluronic L44, ADEKA Corp.) | |
| Tetraethylamine hydrochloride | 0.01 g |

(continued)

| | |
|---|---|
| 1-Methoxy-2-propanol | 3.5 g |
| Methyl ethyl ketone . | 8.0 g |
| Organically modified particles (A-1) | 0.1 g |

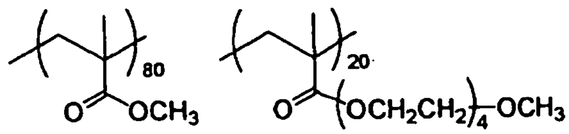

Binder polymer (1)

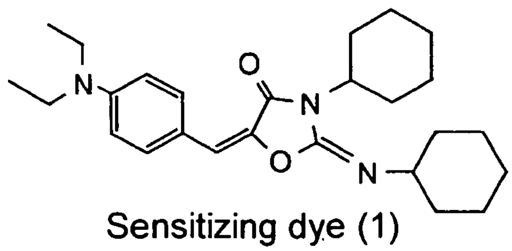

Sensitizing dye (1)

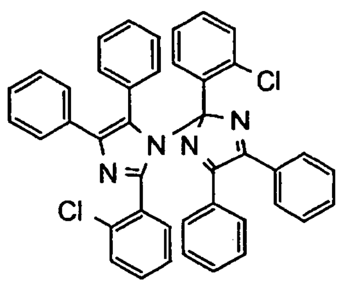

Polymerization initiator (1)

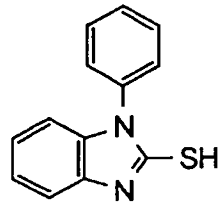

Co-sensitizer (1)

Mixture of compounds below

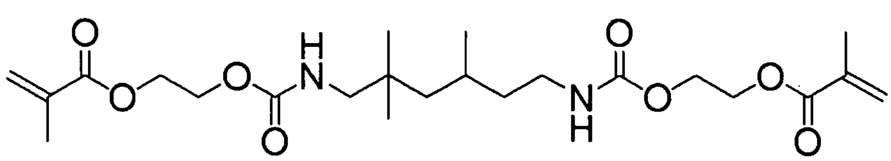

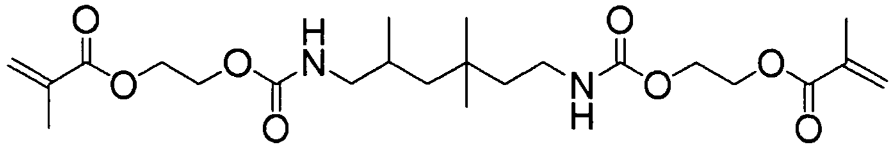

Polymerizable compound (1)

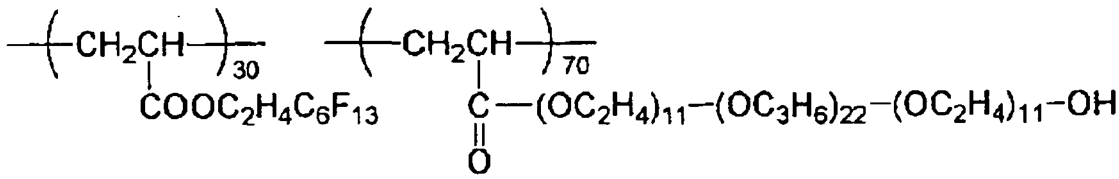

Fluorine-based surfactant (1)

Protective Layer Coating Liquid (1)

| | |
|---|---|
| Polyvinyl alcohol (PVA-105, degree of saponification: 98 mol %; degree of polymerization: 500, Kuraray Co., Ltd.) | 40 g |
| Polyvinylpyrrolidone (molecular weight: 50,000) | 5 g |
| Poly(vinylpyrrolidone/vinyl acetate (1/1)) (molecular weight: 70,000) | 0.5 g |
| Surfactant (Emalex 710, Nihon-Emulsion Co., Ltd.) | 0.5 g |
| Water | 950 g |

Binder polymer (2)

Polyvinyl alcohol (molecular weight: 50,000, degree of saponification: 55%)

Binder polymer (3)

Polyvinyl butyral (molecular weight: 80,000, butyral proportion: 65 mol %, acetate proportion: < 1 mol %)

Binder polymer (4) : P-20 below

| | Diisocyanate structure (mol%) | | Diol structure (mol%) | | | Mw |
|---|---|---|---|---|---|---|
| P-20 | 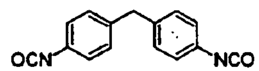 40 | 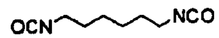 10 | 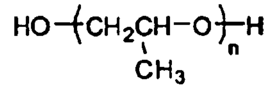 10 (Mw=1000) | 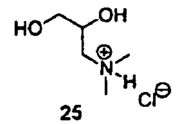 25 | 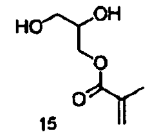 15 | 59000 |

Binder Polymer (5): PA-11

| | Formulation ratio (mol%) | Mw |
|---|---|---|
| PA-11 | **90/10** | **58000** |

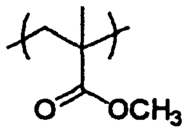
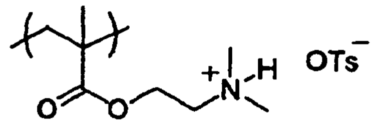

Polymerizable compound (2)

EO-modified isocyanurate triacrylate (Aronix M-315, Toagosei Co., Ltd.)

Polymerizable compound (3)

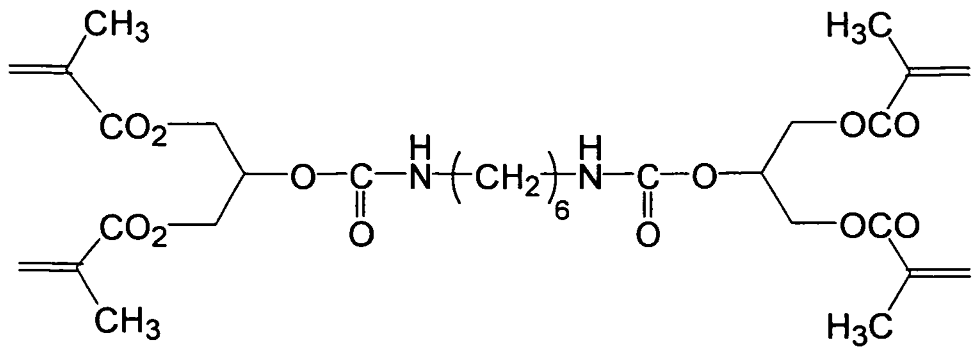

Sensitizing Dye (2)

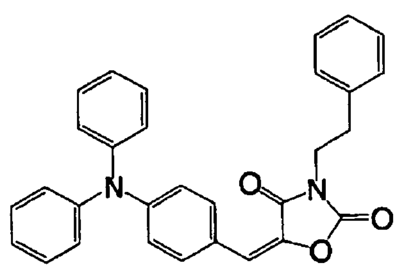

Sensitizing Dye (3)

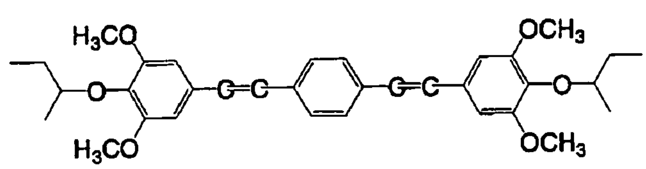

Polymerization Initiator (2)

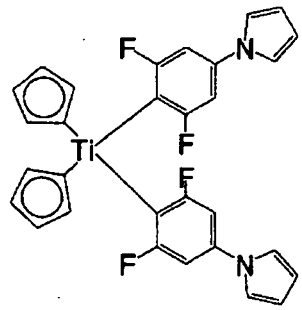

Co-sensitizer (2)

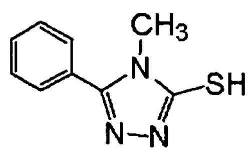

Co-sensitizer (3)

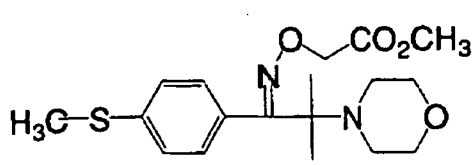

Co-sensitizer (4)

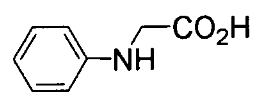

Comparative particles H-1: MP-2040 (colloidal silica, particle size 200 nm, Nissan Chemical Industries, Ltd.)

Examples 1 to 10 and Comparative Examples 1 and 2

Exposure, development, and printing

Lithographic printing plate precursors 1 to 10 and comparative lithographic printing plate precursors 1 and 2 above were imagewise exposed using a Violet semiconductor laser plate setter Vx9600 (equipped with an InGaN semiconductor laser, emission: 405 nm ± 10 nm/output: 30 mW, manufactured by FUJIFILM Electronic Imaging Ltd.). For the image, a 50% screen tint was drawn using an FM screen (TAFFETA 20, Fuji Photo Film Co., Ltd.) with a plate surface exposure of 0.05 mJ/cm$^2$ at a resolution of 2,438 dpi.

Subsequently, development processing was carried out in an automatic development processor having the structure shown in FIG. 1 using developer 1 having the formulation below, thus preparing a lithographic printing plate (without heating). The pH of the developer 1 was 4.6. The automatic development processor was an automatic processor having two rotating brush rollers. As the rotating brush rollers used, the first brush roller was a brush roller having an outer diameter of 90 mm and having implanted therein fibers of polybutylene terephthalate (bristle diameter: 200 μm, bristle length: 17 mm), and the brush roller was rotated at 200 rpm in the same direction as the transport direction (peripheral speed at brush tip: 0.94 m/sec). The second brush roller was a brush roller having an outer diameter of 60 mm having implanted therein fibers of polybutylene terephthalate (bristle diameter: 200 μm, bristle length: 17 mm), and the brush roller was rotated at 200 rpm in the opposite direction to the transport direction (peripheral speed at brush tip: 0.63 m/sec). Transport of the lithographic printing plate precursor was carried out at various transport speeds.

The developer was supplied onto the surface of the lithographic printing plate precursor by showering from a spray pipe using a circulation pump. The tank volume for the developer was 10 liters.

Developer 1 (pH: 4.6)

| | |
|---|---|
| Water | 100.00 g |

(continued)

| | |
|---|---|
| Benzyl alcohol | 1.00 g |
| Polyoxyethylene naphthyl ether | 1.00 g |
| (oxyethylene average number n = 13) Dioctylsulfosuccinic acid ester sodium salt | 0.50 g |
| Gum Arabic (Mw = 250,000) | 1.00 g |
| Ethylene glycol | 0.50 g |
| Ammonium phosphate, monobasic | 0.05 g |
| Citric acid | 0.05 g |
| Tetrasodium ethylenediamine tetraacetate | 0.05 g |

Subsequently, the lithographic printing plate was mounted on a SOR-M printing machine (Heidelberg), and printing was carried out at a printing speed of 6,000 sheets per hour using dampening water (EU-3 (etching liquid, Fuji Photo Film Co., Ltd.))/water/isopropyl alcohol = 1/89/10 (ratio by volume)) and TRANS-G(N) black ink (Dai-Nippon Ink & Chemicals, Inc.).

Evaluation

Plate life, staining resistance, and staining resistance after aging were evaluated as described below. The results are shown in Table 2.

Plate life

The above-mentioned printing was carried out, and as the number of prints increased, since the photosensitive layer was gradually worn and ink acceptability was degraded, the ink density on a printed material decreased. A relative evaluation of plate life was given by the number of prints after which the ink density (reflection density) of a 50% screen tint portion decreased by 0.1 from that of the initial print for printing plates that had been exposed at an identical exposure (energy density). That is, Comparative Example 1 was defined as a reference (100), and calculation was carried out using the equation below. The larger the figure, the longer the plate life.

Plate life = (number of prints from lithographic printing plate in question)/(number of prints from reference lithographic printing plate) x 100

Staining resistance

The 500th print after starting printing was taken out, and a relative evaluation of staining resistance was given by the ink density attached to a non-image area. That is, Comparative Example 1 was defined as a reference (100), and calculation was carried out using the equation below. The larger the figure, the lower the ink density of the non-image area, that is, the better the staining resistance.

Staining resistance = (ink density of non-image area of print obtained using reference lithographic printing plate)/(ink density of non-image area of print obtained using lithographic printing plate in question) x 100

Staining resistance after aging

The lithographic printing plate precursor was stored at 60°C for 3 days, subsequently exposure, development, and printing were carried out in the same manner as above, and the staining resistance was evaluated. The staining resistance of Comparative Example 1 (without aging) was defined as a reference (100). The larger the figure, the better the staining resistance after aging.

Development speed

With regard to lithographic printing plate precursors 1 to 10 and comparative lithographic printing plate precursors 1 and 2, a relative evaluation of the development speed under the above-mentioned development conditions was given by the transport speed required for completely removing the non-image area of the lithographic printing plate precursor. That is, Comparative Example 1 was defined as a reference (100), and calculation was carried out using the equation below. The larger the figure, the higher the development speed.

Development speed = (transport speed required for removing non-image area of lithographic printing plate precursor in question)/(transport speed required for removing non-image area of reference lithographic printing plate precursor) x 100

Evaluation of development residue

After lithographic printing plate precursors 1 to 10 and comparative lithographic printing plate precursors 1 and 2 (area 0.88 $m^2$) were exposed so that the non-image area was 0.75 $m^2$, the above-mentioned development processing was carried out consecutively therewith. The number processed when development residue started to be deposited in the developer after processing was checked, Comparative Example 1 was defined as a reference (100), and an evaluation value for the ability to suppress development residue was obtained from the equation below. The larger the value, the better the suppression of the occurrence of development residue, and the better the performance.

Ability to suppress development residue = (number processed when development residue occurred when using lithographic printing plate in question)/(number processed when development residue occurred when using reference lithographic printing plate) x 100

The results are shown in Table 2.

Examples 11 to 20 and Comparative Examples 3 and 4

Exposure, development, and printing

Lithographic printing plate precursors 1 to 10 and comparative lithographic printing plate precursors 1 and 2 were imagewise exposed in the same manner as above.

Within 30 sec after imagewise exposure, the lithographic printing plate precursors were placed in an oven, the entire surface of the lithographic printing plate precursors was heated by blowing hot air, and they were held at 110˚C for 15 sec.

Within 30 sec thereafter, development processing was carried out in the same manner as above.

Subsequently, plate life, staining resistance, and staining resistance after aging were evaluated in the same manner as above, and they were defined as Examples 11 to 20 and Comparative Examples 3 and 4.

The results are given in Table 2.

(Table 2)

| Developer 1 not heated | Ex. 1 | Comp. Ex. 1 | Comp. Ex. 2 | Ex. 2 | Ex. 3 | Ex. 4 | Ex. 5 | Ex. 6 | Ex. 7 | Ex. 8 | Ex. 9 | Ex. 10 |
|---|---|---|---|---|---|---|---|---|---|---|---|---|
| Lithographic printing plate precursor | 1 | Comparative 1 | Comparative | 2 | 3 | 4 | 5 | 6 | 7 | 8 | 9 | 10 |
| Component(A) | A-1 | None | H-1 | A-2 | A-3 | A-4 | A-5 | A-6 | A-7 | A-8 | A-9 | A-10 |
| Initiator | 1 | 1 | 1 | 1 | 1 | 2 | 1 | 1 | 2 | 1 | 1 | 1 |
| Polymerizable compound | 1 | 1 | 1 | 1 | 3 | 1 | 2 | 3 | 1 | 1 | 1 | 1 |
| Binder | 1 | 1 | 1 | 4 | 1 | 3 | 4 | 4 | 1 | 1 | 1 | 3 |
| Sensitizing dye | 1 | 1 | 1 | 1 | 2 | 2 | 1 | 1 | 2 | 1 | 1 | 3 |
| Co-sensitizer | 1 | 1 | 1 | 1 | 1 | 2 | 4 | 2 | 1 | 3 | 3 | 1 |
| Development speed | 170 | 100 | 160 | 160 | 160 | 170 | 160 | 170 | 150 | 160 | 170 | 160 |
| Suppression of development residue | 300 | 100 | 280 | 280 | 270 | 320 | 290 | 270 | 300 | 260 | 270 | 280 |
| Staining resistance (immediately after coating) | 320 | 100 | 180 | 330 | 300 | 310 | 280 | 310 | 290 | 320 | 310 | 280 |
| Staining resistance (After aging at 60˚C for 3 days) | 320 | 20 | 150 | 320 | 280 | 270 | 270 | 290 | 270 | 310 | 300 | 270 |
| Plate life | 210 | 100 | 20 | 150 | 190 | 200 | 170 | 180 | 190 | 160 | 170 | 190 |
| Developer 1 heated | Ex. 11 | Comp. Ex. 3 | Comp. Ex. 4 | Ex. 12 | Ex. 13 | Ex. 14 | Ex. 15 | Ex. 16 | Ex. 17 | Ex. 18 | Ex. 19 | Ex. 20 |
| Staining resistance (Immediately after coating) | 300 | 96 | 160 | 310 | 290 | 280 | 270 | 280 | 270 | 300 | 300 | 280 |
| Staining resistance (After aging at 60˚C for 3 days) | 295 | 15 | 140 | 300 | 280 | 265 | 255 | 270 | 255 | 290 | 290 | 260 |
| Plate life | 245 | 120 | 35 | 180 | 220 | 215 | 220 | 210 | 200 | 185 | 185 | 215 |

Preparation of lithographic printing plate precursors 11 to 17 and comparative lithographic printing plate precursors 3 and 4

Lithographic printing plate precursor 11 was prepared in the same manner as for lithographic printing plate precursor 1 except that photosensitive layer coating liquid (1) was changed to photosensitive layer coating liquid (11) shown below.

Photosensitive layer coating liquids (12) to (17) and comparative photosensitive layer coating liquids (3) and (4) were prepared in the same manner as for photosensitive layer coating liquid (11) except that the materials used were changed to those described in Table 3 below, thus giving lithographic printing plate precursors 12 to 17 and comparative lithographic printing plate precursors 3 and 4.

Photosensitive Layer Coating Liquid (11)

| | |
|---|---|
| Binder polymer (6) below | 0.48 g |
| Polymerizable compound (1) above | 0.54 g |
| Sensitizing dye (1) above | 0.06 g |
| Polymerization initiator (1) above | 0.08 g |
| Co-sensitizer (1) above | 0.07 g |
| ε-Phthalocyanine pigment dispersion | 0.40 g |
| (pigment: 15 parts by weight, dispersant binder polymer (1): 10 parts by weight, solvent: cyclohexanone/methoxypropyl acetate/1-methoxy-2-propanol = 15 parts by weight/20 parts by weight/40 parts by weight) | 0.01 g |
| Thermal polymerization inhibitor | |
| (N-Nitrosophenylhydroxylamine aluminum salt) | |
| Fluorine-based surfactant (1) above | 0.001 g |
| Polyoxyethylene-polyoxypropylene condensate | 0.04 g |
| (Pluronic L44, ADEKA Corp.) | |
| Tetraethylamine hydrochloride | 0.01 g |
| 1-Methoxy-2-propanol | 3.5 g |
| Methyl ethyl ketone | 8.0 g |
| Organically modified particles (A-1) | 0.1 g |

Binder polymer (6)

Methacrylic acid/methyl methacrylate copolymer (molecular weight: 40,000, molar ratio: 30/70)

Binder polymer (7)

Acrylic acid/benzyl methacrylate copolymer (molecular weight: 50,000, molar ratio: 25/75)

Binder polymer (8)

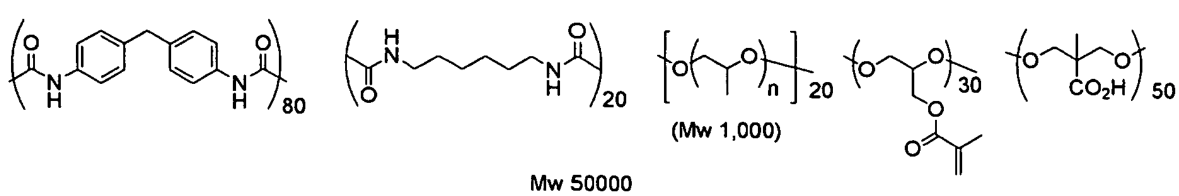

(Mw 1,000)

Mw 50000

Examples 21 to 27 and Comparative Examples 5 and 6

Exposure, development, and printing

Lithographic printing plate precursors 11 to 17 and comparative lithographic printing plate precursors 3 and 4 were imagewise exposed in the same manner as above.

Within 30 sec after imagewise exposure, the lithographic printing plate precursors were placed in an oven, the entire surface of the lithographic printing plate precursors was heated by blowing hot air, and they were held at 110˚C for 15 sec.

Within 30 sec thereafter, development processing was carried out in the same manner as above. As the developer, developer 2 below was used. The pH of the developer 2 was 9.7.

Subsequently, plate life, staining resistance, staining resistance after aging, development speed, and development residue were evaluated in the same manner as above, and they were defined as Examples 21 to 27 and Comparative Examples 5 and 6. As the developer, developer 2 below was used.

For evaluation of plate life, staining resistance, staining resistance after aging, development speed, and development residue, Comparative Example 5 was defined as a reference (100).

Developer 2 (pH: 9.7)

| | |
|---|---|
| Water | 8329.80 g |
| Sodium carbonate | 130.00 g |
| Sodium hydrogen carbonate | 70.00 g |
| Newcol B13 | 500.00 g |
| Gum Arabic (Mw = 250,000) | 250.00 g |
| Hydroxyalkylated starch (Penon JE66, Nippon Starch Chemical Co., Ltd.) | 700.00 g |
| Ammonium phosphate, monobasic | 20.00 g |
| 2-Bromo-2-nitropropane-1,3-diol | 0.10 g |
| 2-Methyl-4-isothiazolin-3-one | 0.10 g |

The results are shown in Table 3.

(Table 3)

| Developer 2 heated | Example 21 | Comp. Ex. 5 | Comp. Ex. 6 | Example 22 | Example 23 | Example 24 | Example 25 | Example 26 | Example 27 |
|---|---|---|---|---|---|---|---|---|---|
| Lithographic printing plate precursor | 11 | Comparative 3 | Comparative 4 | 12 | 13 | 14 | 15 | 16 | 17 |
| Component(A) | A-1 | None | H-1 | A-2 | A-8 | A-9 | A-11 | A-12 | A-3 |
| Initiator | 1 | 1 | 1 | 1 | 2 | 1 | 1 | 1 | 1 |
| Polymerizable compound | 1 | 1 | 1 | 3 | 1 | 2 | 1 | 1 | 1 |
| Binder | 6 | 6 | 6 | 7 | 8 | 3 | 6 | 6 | 11 |
| Sensitizing dye | 1 | 1 | 1 | 3 | 2 | 1 | 1 | 1 | 3 |
| Co-sensitizer | 1 | 1 | 1 | 3 | 2 | 4 | 1 | 1 | 1 |
| Development speed | 270 | 100 | 160 | 280 | 270 | 260 | 270 | 260 | 260 |
| Suppression of development residue | 250 | 100 | 180 | 240 | 260 | 250 | 240 | 230 | 240 |
| Staining resistance (Immediately after coating) | 280 | 100 | 150 | 270 | 270 | 260 | 270 | 260 | 270 |
| Staining resistance (After aging at 60˚C for days) | 270 | 30 | 135 | 265 | 250 | 245 | 260 | 250 | 260 |
| Plate life | 195 | 100 | 15 | 140 | 180 | 170 | 170 | 195 | 190 |

Preparation of lithographic printing plate precursors 18 to 25 and comparative lithographic printing plate precursors 5 to 8

A middle layer and a photosensitive layer were prepared in the same manner as for lithographic printing plate precursor 1 except that photosensitive layer coating liquid (1) above was changed to photosensitive layer coating liquid (18) below, subsequently protective layer coating liquid (2) below was applied using a bar at a dry coat weight of 1.2 $g/m^2$, and drying was then carried out at 125°C for 70 sec to form a protective layer, thus giving lithographic printing plate precursor 18.

Photosensitive layer coating liquids (19) to (25) and comparative photosensitive layer coating liquids (5) to (8) were prepared in the same manner as for photosensitive layer coating liquid (18) except that the materials used were changed to those described in Table 4 and Table 5, thus giving lithographic printing plate precursors 19 to 25 and comparative lithographic printing plate precursors 5 to 8.

Photosensitive layer coating liquid (18)

| | |
|---|---|
| Binder polymer (9) below | 0.623 g |
| Polymerization initiator (4) below | 0.155 g |
| Polymerizable compound (4) below | 0.428 g |
| Sensitizing dye (6) below | 0.038 g |
| Copper phthalocyanine pigment dispersion | 0.159 g |
| Co-sensitizer A: co-sensitizer (1) above | 0.015 g |
| Co-sensitizer B: co-sensitizer (5) below | 0.081 g |
| Thermal polymerization inhibitor | 0.0012 g |
| (N-Nitrosophenylhydroxylamine aluminum salt) | |
| Fluorine-based surfactant | 0.0081 g |
| (Megafac F-176, Dainippon Ink and Chemicals, Incorporated) Methyl ethyl ketone | 5.856 g |
| Methanol | 2.733 g |
| 1-Methoxy -2-propanol | 5.886 g |
| Organically modified particles (A-1) | 0.12 g |

Protective layer coating liquid (2)

| | |
|---|---|
| Mica dispersion (1) below | 13.00 g |
| Polyvinyl alcohol (degree of saponification 98 mol %, degree of polymerization 500) | 1.30 g |
| Sodium 2-ethylhexylsulfosuccinate | 0.20 g |
| Poly(vinylpyrrolidone/vinyl acetate (1/1)) molecular weight 70,000 | 0.050 g |
| Surfactant (EMALEX 710, Nihon Emulsion Co., Ltd.) | 0.050 g |
| Water | 133.00 g |

Mica Dispersion (1)

32 g of synthetic mica ('SOMASIF ME-100', CO-OP Chemical Co., Ltd.; aspect ratio: 1,000 or greater) was added to 368 g of water and dispersed using a homogenizer until the average particle size (laser scattering method) became 0.5 μm, thus giving mica dispersion (1).

Polymerization Initiator (3)

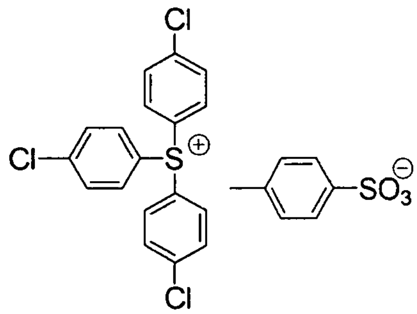

Polymerization Initiator (4)

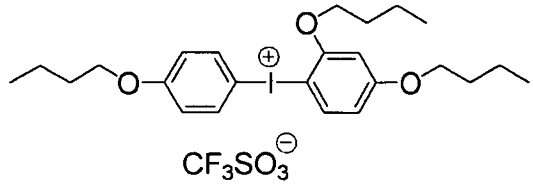

Polymerization Initiator (5)

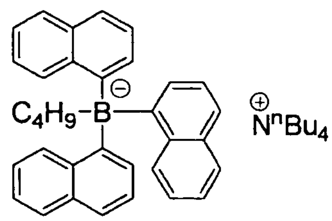

Polymerization compound (4)

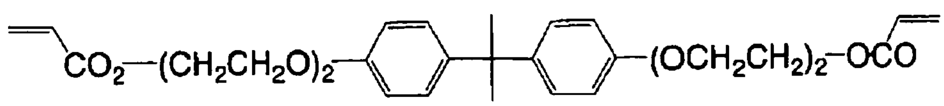

Polymerizable compound (5)

Dipentaerythritol pentaacrylate (SR399, Sartomer Company Inc.)

Binder polymer (9)

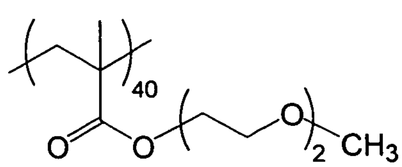

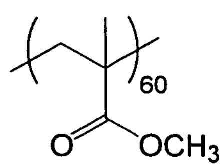

Mw = 80,000

Binder polymer (10)

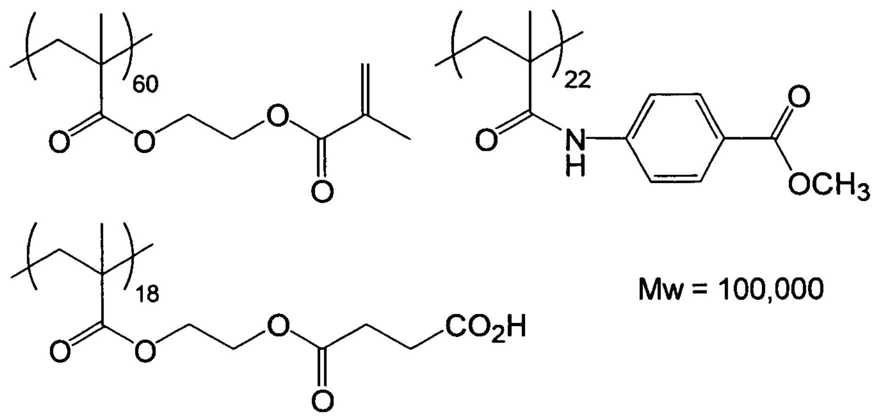

Mw = 100,000

Binder polymer (11)

Koma 30 (a trimellitic acid modified vinyl butylal/vinyl alcohol/vinyl acetate copolymer, manufactured by Clariant)

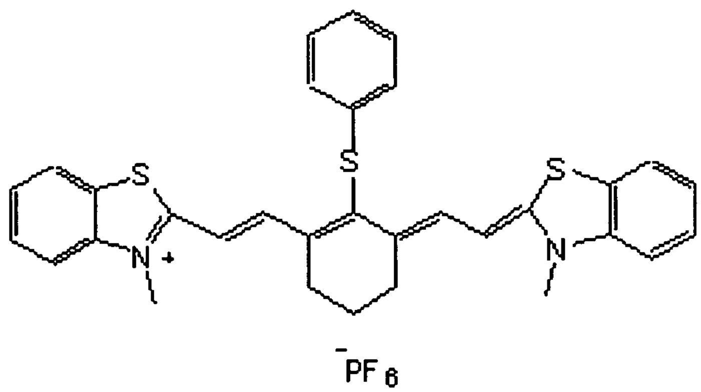

Sensitizing dye (4)

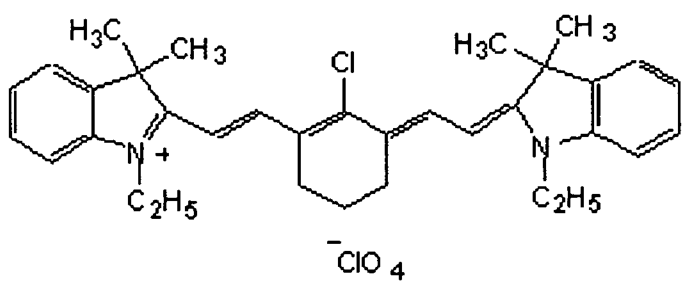

Sensitizing dye (5)

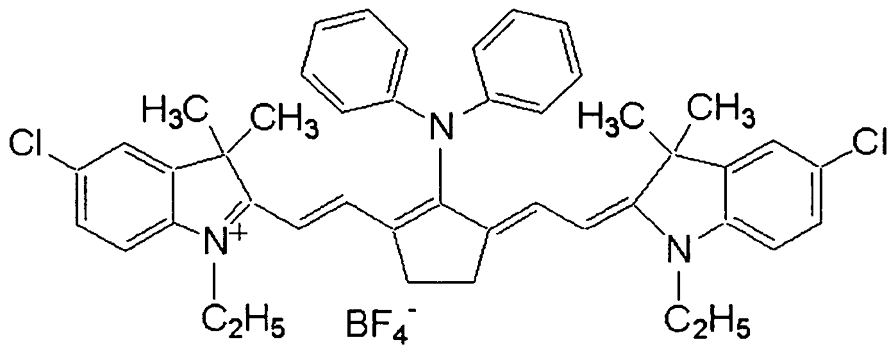

Sensitizing dye (6)

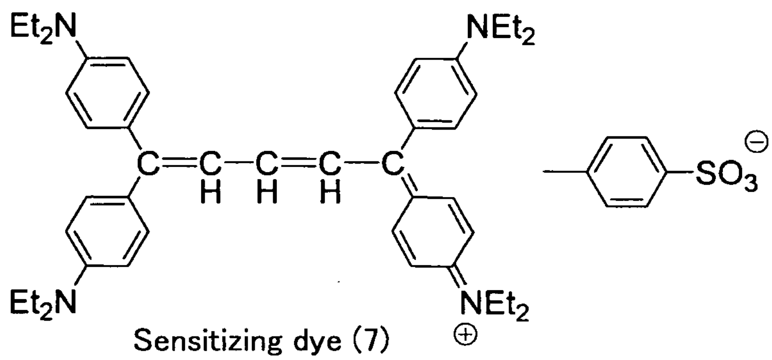

Sensitizing dye (7)

Et denotes an ethyl group.

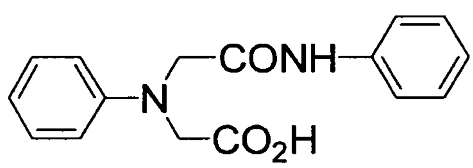

Co-sensitizer (5)

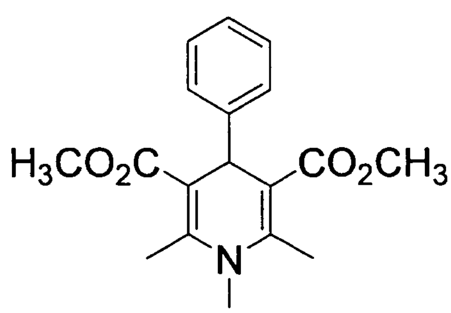

Co-sensitizer (6)

Examples 28 to 31 and Comparative Examples 7 and 8

Exposure, development, and printing

Lithographic printing plate precursors 18 to 21 and comparative lithographic printing plate precursors 5 and 6 were exposed using a Trendsetter 3244VX equipped with a water-cooled 40 W IR semiconductor laser (Creo) under conditions of an output of 9 W, an exterior drum rotational speed of 210 rpm, and a resolution of 2,400 dpi.
After imagewise exposure, development processing was carried out in the same manner as in Example 1 except that developer 1 was changed to developer 3 below, thus giving a lithographic printing plate.

Evaluation

The lithographic printing plates thus obtained were evaluated in the same manner as in Example 1 in terms of plate life, staining resistance, and staining resistance after aging as Examples 28 to 31 and Comparative Example 7 and 8. As the developer, developer 3 below was used.
The plate life, staining resistance, staining resistance after aging, and development speed of Comparative Example 7 were defined as a reference (100).

Developer 3 (pH: 5.0)

| | |
|---|---|
| Water | 100.00 g |
| N-Lauryldimethylbetaine | 10.00 g |
| (Pionin C157K, Takemoto Oil & Fat Co., Ltd.) Polystyrenesulfonic acid (Mw = 20,000) | 1.00 g |
| Ammonium phosphate, monobasic | 0.05 g |
| Citric acid | 0.05 g |
| Tetrasodium ethylene diamine tetraacetate | 0.05 g |

The pH was adjusted to 5.0 using phosphoric acid.
The results are shown in Table 4.

(Table 4)

| Developer 3 | Example 28 | Comp. Ex. 7 | Comp. Ex. 8 | Example 29 | Example 30 | Example 31 |
|---|---|---|---|---|---|---|
| Lithographic printing plate precursor | 18 | Comparative 5 | Comparative 6 | 19 | 20 | 21 |
| Component (A) | A-1 | None | H-1 | A-2 | A-8 | A-9 |
| Initiator | 4 | 4 | 3 | 4 | 5 | 3 |
| Polymerizable compound | 4 | 4 | 4 | 5 | 3 | 1 |
| Binder | 9 | 9 | 9 | 3 | 1 | 4 |
| Sensitizing dye | 6 | 6 | 6 | 7 | 5 | 4 |
| Co-sensitizer A | 1 | 1 | 1 | 2 | 2 | 1 |
| Co-sensitizer B | 5 | 5 | 5 | 6 | 4 | 5 |
| Development speed | 260 | 100 | 170 | 275 | 270 | 265 |
| Suppression of development residue | 260 | 100 | 175 | 245 | 255 | 270 |
| Staining resistance (Immediately after coating) | 275 | 100 | 160 | 265 | 270 | 260 |

(continued)

| Developer 3 | Example 28 | Comp. Ex. 7 | Comp. Ex. 8 | Example 29 | Example 30 | Example 31 |
|---|---|---|---|---|---|---|
| Staining resistance (After aging at 60°C for 3 days) | 270 | 30 | 145 | 265 | 250 | 250 |
| Plate life | 190 | 100 | 20 | 145 | 170 | 180 |

Examples 32 to 35 and Comparative Examples 9 and 10

Exposure, development, and printing

Lithographic printing plate precursors 22 to 25 and comparative lithographic printing plate precursors 7 and 8 above were imagewise exposed in the same manner as in Examples 28 to 31 and Comparative Examples 7 and 8.

After imagewise exposure, development processing was carried out in the same manner as in Examples 28 to 31 and Comparative Examples 7 and 8 except that developer 3 was changed to developer 4 below, thus preparing lithographic printing plates. The pH of developer 4 was 9.7.

Evaluation

The lithographic printing plates thus obtained were evaluated in the same manner as in Example 1 in terms of plate life, staining resistance, and staining resistance after aging as Examples 32 to 35 and Comparative Examples 9 and 10. As the developer, developer 4 was used.

The plate life, staining resistance, staining resistance after aging, and development speed of Comparative Example 9 were defined as a reference (100).

Developer 4 (pH: 9.7)

| | |
|---|---|
| Water | 8260.00 g |
| Potassium carbonate | 150.00 g |
| Potassium hydrogen carbonate | 70.00 g |
| Eleminol MON (100% conversion, Sanyo Chemical Industries, Ltd.) | 350.00 g |
| Yellow dextrin (Red Ball Dextrin 102, Nippon Starch Chemical Co., Ltd.) | 800.00 g |
| Hydroxyalkylated starch (Penon JE66, Nippon Starch Chemical Co., Ltd.) | 700.00 g |
| Ammonium phosphate, monobasic | 180.00 g |
| Sodium hexametaphosphate | 180.00 g |

The results are shown in Table 5.

(Table 5)

| Developer 4 | Example 32 | Comp. Ex. 9 | Comp. Ex. 10 | Example 33 | Example 34 | Example 35 |
|---|---|---|---|---|---|---|
| Lithographic printing plate precursor | 22 | Comparative 7 | Comparative 8 | 23 | 24 | 25 |
| Component (A) | A-1 | None | H-1 | A-2 | A-8 | A-9 |
| Initiator | 4 | 4 | 3 | 4 | 5 | 3 |
| Polymerizable compound | 4 | 4 | 4 | 1 | 3 | 5 |
| Binder | 10 | 10 | 10 | 8 | 7 | 6 |
| Sensitizing dye | 6 | 6 | 6 | 7 | 5 | 4 |
| Co-sensitizer A | 1 | 1 | 1 | 2 | 2 | 1 |

(continued)

| Developer 4 | Example 32 | Comp. Ex. 9 | Comp. Ex. 10 | Example 33 | Example 34 | Example 35 |
|---|---|---|---|---|---|---|
| Co-sensitizer B | 5 | 5 | 5 | 6 | 5 | 4 |
| Development speed | 305 | 100 | 165 | 290 | 285 | 290 |
| Suppression of development residue | 280 | 100 | 170 | 275 | 260 | 280 |
| Staining resistance (Immediately after coating) | 280 | 100 | 170 | 270 | 260 | 280 |
| Staining resistance (After aging at 60˚C for 3 days) | 270 | 35 | 155 | 270 | 260 | 270 |
| Plate life | 185 | 100 | 15 | 140 | 175 | 170 |

Examples 36 to 40 and Comparative Examples 11 and 12

Exposure, development, and printing were carried out in the same manner as in Example 21 using developer 5 below thus obtained, thus giving lithographic printing plates.

The lithographic printing plates thus obtained were evaluated in the same manner as in Example 21 in terms of plate life, staining resistance, and staining resistance after aging as Examples 36 to 40 and Comparative Examples 11 and 12.

The evaluation results are shown in Table 6.

Developer 5 (pH: 6.9)

| | |
|---|---|
| Water | 100 g |
| Diethanolamine | 0.10 g |
| Triethanolamine | 0.15 g |
| Newcol B13 | 3 g |
| Polyethyleneglycol monophenyl ether (oxyethylene average number n = 22) | 5g |
| Gum Arabic | 2 g |
| 2-Methyl-4-isothiazoline-3-one | 0.01 g |

(Table 6)

| Developer 5 heated | Example 36 | Comp. Ex. 11 | Comp. Ex. 12 | Example 37 | Example 38 | Example 39 | Example 40 |
|---|---|---|---|---|---|---|---|
| Lithographic printing plate precursor | 11 | Comparative 3 | Comparative 4 | 12 | 13 | 14 | 17 |
| Component (A) | A-1 | None | H-1 | A-2 | A-8 | A-9 | A-3 |
| Initiator | 1 | 1 | 1 | 1 | 2 | 1 | 1 |
| Polymerizable compound | 1 | 1 | 1 | 3 | 1 | 2 | 1 |
| Binder | 6 | 6 | 6 | 7 | 8 | 3 | 11 |

(continued)

| Developer 5 heated | Example 36 | Comp. Ex. 11 | Comp. Ex. 12 | Example 37 | Example 38 | Example 39 | Example 40 |
|---|---|---|---|---|---|---|---|
| Sensitizing dye | 1 | 1 | 1 | 3 | 2 | 1 | 3 |
| Co-sensitizer | 1 | 1 | 1 | 3 | 2 | 4 | 1 |
| Development speed | 250 | 100 | 150 | 260 | 250 | 240 | 240 |
| Suppression of development residue | 230 | 100 | 170 | 220 | 240 | 230 | 230 |
| Staining resistance (Immediately after coating) | 260 | 100 | 130 | 250 | 250 | 240 | 250 |
| Staining resistance (After aging at 60˚C for 3 days) | 270 | 30 | 120 | 240 | 240 | 230 | 240 |
| Plate life | 170 | 100 | 20 | 130 | 160 | 150 | 170 |

## Claims

**1.** A process for making a lithographic printing plate, comprising:

an exposure step of imagewise exposing a lithographic printing plate precursor that comprises, above a hydrophilic support, a photosensitive layer comprising a binder polymer, an ethylenically unsaturated compound, a polymerization initiator, and organically modified particles (A) having a particle size of at least 1 nm but no greater than 100 nm; and

a development processing step of carrying out development processing by one type of processing liquid having a pH of at least 2 but less than 11.

**2.** The process for making a lithographic printing plate according to Claim 1, wherein the organically modified particles (A) are particles having the particle surface thereof modified by an ethylenically unsaturated bond-containing group.

**3.** The process for making a lithographic printing plate according to Claim 1 or 2, wherein the organically modified particles (A) are organically modified silica particles.

**4.** The process for making a lithographic printing plate according to any one of Claims 1 to 3, wherein the organically modified particles (A) are organically modified particles represented by (1) below,

$$P\text{-}[(Y)_s\text{-}\{(U^1)_p\text{-}(U^2\text{-}Z)_t\}_m]_k \quad (1)$$

wherein P denotes a particle support, Y denotes a coupling residue, k is an integer of 1 or more, m is an integer of 1 or more, s is 0 or 1, p is 0 or 1, t denotes an integer of 1 or more, $U^1$ denotes a first linking unit, $U^2$ denotes a second linking unit, and Z denotes a monovalent organic group.

**5.** The process for making a lithographic printing plate according to any one of Claims 1 to 4, wherein the photosensitive layer comprises a sensitizing dye.

6. The process for making a lithographic printing plate according to Claim 5, wherein the sensitizing dye is a cyanine dye.

7. The process for making a lithographic printing plate according to Claim 5, wherein the sensitizing dye is a dye represented by Formula (IX) below,

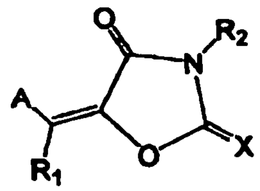

(IX)

wherein A denotes an optionally substituted aryl group or heterocyclic group, X denotes an oxygen atom, a sulfur atom, or $=N(R_3)$, $R_1$, $R_2$, and $R_3$ independently denote a monovalent non-metallic atomic group, and A and $R_1$ and/or $R_2$ and $R_3$ may be bonded to each other to form an aliphatic or aromatic ring.

8. The process for making a lithographic printing plate according to Claim 6, wherein the cyanine dye is a dye represented by Formula (a) below,

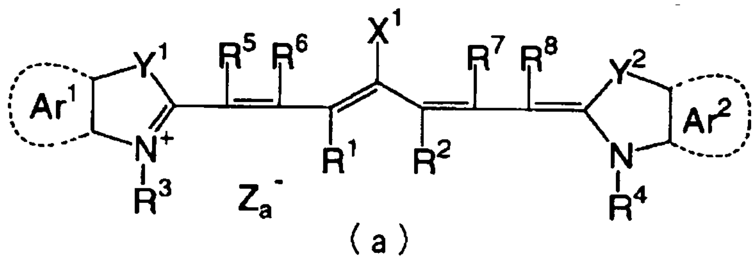

(a)

wherein $X^1$ denotes a hydrogen atom, a halogen atom, $-NPh_2$, or an $-X^2-L^1$ group, $X^2$ denoting an oxygen atom, a nitrogen atom, or a sulfur atom and $L^1$ denoting a hydrocarbon group having 1 to 12 carbon atoms, a hetero atom-containing aromatic ring, or a hetero atom-containing hydrocarbon group having 1 to 12 carbon atoms,
$R^1$ and $R^2$ independently denote a hydrocarbon group having 1 to 12 carbon atoms,
$Ar^1$ and $Ar^2$ may be identical to or different from each other and denote an optionally substituted aromatic hydrocarbon group,
$Y^1$ and $Y^2$ may be identical to or different from each other and denote a sulfur atom or a dialkylmethylene group C(Rx)(Ry) having no greater than 12 carbon atoms,
Rx and Ry independently denote an alkyl group having 1 to 10 carbon atoms,
$R^3$ and $R^4$ may be identical to or different from each other and denote an optionally substituted hydrocarbon group having no greater than 20 carbon atoms,
$R^5$, $R^6$, $R^7$ and $R^8$ may be identical to or different from each other and denote a hydrogen atom or a hydrocarbon group having no greater than 12 carbon atoms, and
$Z_a^-$ denotes a counteranion.

9. The process for making a lithographic printing plate according to any one of Claims 1 to 8, wherein the processing liquid is an aqueous solution comprising a water-soluble polymer.

10. The process for making a lithographic printing plate according to any one of Claims 1 to 9, wherein the development processing step is a step in which at least two of removal of a protective layer, removal of a non-exposed portion of the photosensitive layer, and gumming of the lithographic printing plate precursor are carried out in a single bath.

11. The process for making a lithographic printing plate according to any one of Claims 1 to 10, wherein a water-washing step is not carried out either prior to or subsequent to the development processing step.

*FIG.1*

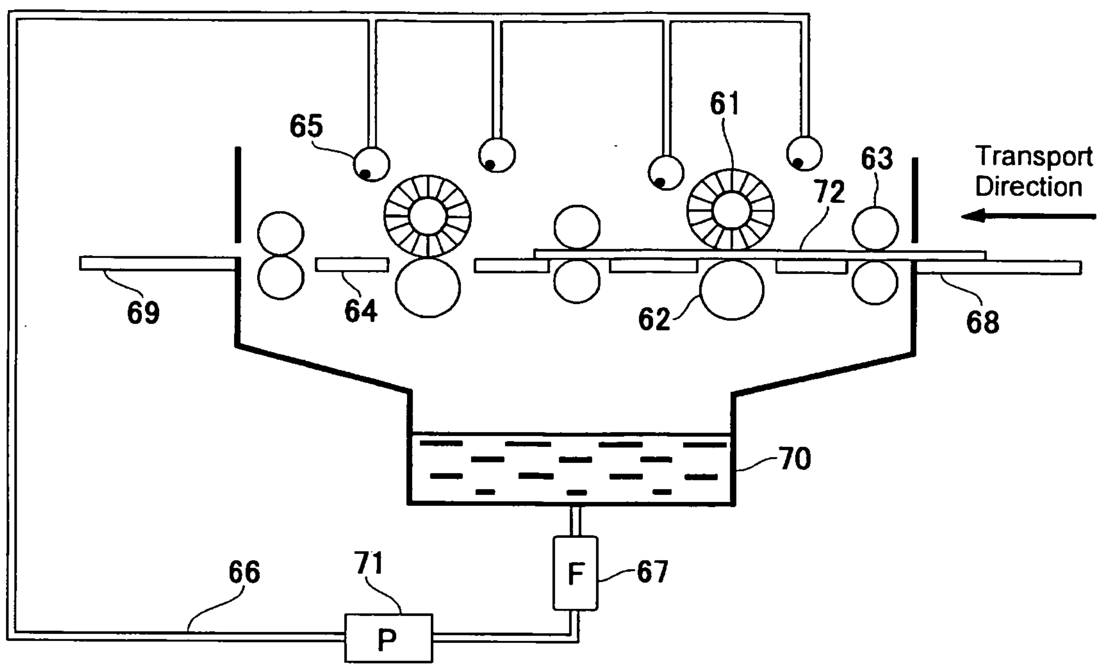

Europäisches Patentamt
European Patent Office
Office européen des brevets

# EUROPEAN SEARCH REPORT

Application Number
EP 09 01 2152

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y | EP 1 880 978 A1 (EASTMAN KODAK CO [US]) 23 January 2008 (2008-01-23)<br>* paragraphs [0124], [0151], [0127] - [0130], [0129] - [0130], [0123]; examples 1-5; table 1 *<br>* paragraph [0011] - paragraph [0018]; figure 1 *<br>* paragraph [0042] - paragraph [0044] *<br>----- | 1-6,8-11<br><br>7 | INV.<br>B41C1/10<br>G03F7/004<br>G03F7/027<br>G03F7/038<br>G03F7/075<br><br>ADD.<br>C09C1/30 |
| X<br><br>Y | EP 1 865 378 A1 (KODAK GRAPHIC COMM JAPAN LTD [JP]) 12 December 2007 (2007-12-12)<br>* paragraphs [0136], [0138], [0140], [0116]; tables 1,3 *<br>* paragraphs [0051], [0052] *<br>* paragraph [0085] - paragraph [0087] *<br>----- | 1-6,8-11<br><br>7 | |
| X<br><br><br>Y | EP 1 739 482 A1 (FUJI PHOTO FILM CO LTD [JP] FUJIFILM CORP [JP]) 3 January 2007 (2007-01-03)<br>* paragraphs [0294] - [0297], [0288]; examples 29-34; table 6 *<br>* paragraph [0174] - paragraph [0176]; claims 9,11 *<br>* paragraph [0105] *<br>----- | 1-4, 10-11<br><br><br>5,7 | TECHNICAL FIELDS SEARCHED (IPC)<br>B41C<br>G03F |
| X,P | WO 2009/114056 A1 (EASTMAN KODAK CO [US]; HAUCK GERHARD [DE]; SAVARIAR-HAUCK CELIN [DE];) 17 September 2009 (2009-09-17)<br>* page 43, line 30 - page 44, line 8; example 4; tables III, II *<br>----- | 1,3,5-6, 8 | |
| Y,D | JP 2005 043660 A (FUJI PHOTO FILM CO LTD) 17 February 2005 (2005-02-17)<br>* paragraph [0012] - paragraph [0018]; claim 1 *<br>* paragraph [0088]; examples 1-10; compounds C1, (C-2) *<br>-----<br>-/-- | 1-11 | |

The present search report has been drawn up for all claims

| Place of search | Date of completion of the search | Examiner |
|---|---|---|
| Munich | 5 February 2010 | Beckert, Audrey |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

1

EPO FORM 1503 03.82 (P04C01)

Europäisches Patentamt
European Patent Office
Office européen des brevets

# EUROPEAN SEARCH REPORT

Application Number
EP 09 01 2152

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 1 630 618 A2 (FUJI PHOTO FILM CO LTD [JP] FUJIFILM CORP [JP]) 1 March 2006 (2006-03-01) * paragraph [0313] - paragraph [0316]; examples 1-7 * * paragraphs [0199], [0210] - [0213], [0220]; figure 1 * * paragraph [0153] - paragraph [0155] * * paragraph [0116] * ----- | 1-11 | |
| A | JP 2005 300623 A (FUJI PHOTO FILM CO LTD) 27 October 2005 (2005-10-27) * the whole document * ----- | 1-11 | |
| A | EP 1 795 964 A2 (DU PONT [US]) 13 June 2007 (2007-06-13) * the whole document * * paragraphs [0026], [0027], [0029], [0030] * * paragraph [0048] - paragraph [0051] * ----- | 1-11 | TECHNICAL FIELDS SEARCHED (IPC) |
| A | WO 2008/029777 A1 (ASAHI CHEMICAL CORP [JP]; FUNAKOSHI SHINJI [JP]; OKITA KOUSHI [JP]; YA) 13 March 2008 (2008-03-13) * the whole document * * paragraphs [0033], [0034], [0040] * ----- | 1-11 | |

The present search report has been drawn up for all claims

| Place of search | Date of completion of the search | Examiner |
|---|---|---|
| Munich | 5 February 2010 | Beckert, Audrey |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 01 2152

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2010

| Patent document cited in search report | Publication date | Patent family member(s) | Publication date |
|---|---|---|---|
| EP 1880978 A1 | 23-01-2008 | CN 101175695 A | 07-05-2008 |
| | | JP 2006317716 A | 24-11-2006 |
| | | WO 2006121172 A1 | 16-11-2006 |
| | | US 2009092923 A1 | 09-04-2009 |
| EP 1865378 A1 | 12-12-2007 | CN 101167017 A | 23-04-2008 |
| | | JP 2006276768 A | 12-10-2006 |
| | | WO 2006109454 A1 | 19-10-2006 |
| | | US 2008280228 A1 | 13-11-2008 |
| EP 1739482 A1 | 03-01-2007 | WO 2005091068 A1 | 29-09-2005 |
| | | US 2007224535 A1 | 27-09-2007 |
| WO 2009114056 A1 | 17-09-2009 | US 2009233227 A1 | 17-09-2009 |
| JP 2005043660 A | 17-02-2005 | NONE | |
| EP 1630618 A2 | 01-03-2006 | AT 389900 T | 15-04-2008 |
| | | DE 602005005403 T2 | 23-04-2009 |
| | | US 2006046199 A1 | 02-03-2006 |
| JP 2005300623 A | 27-10-2005 | NONE | |
| EP 1795964 A2 | 13-06-2007 | JP 2007164178 A | 28-06-2007 |
| | | US 2007134596 A1 | 14-06-2007 |
| WO 2008029777 A1 | 13-03-2008 | EP 2060405 A1 | 20-05-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005043660 A
- US 20040013968 A
- JP 2007316582 A
- WO 0246841 A
- JP 2003192348 A
- WO 2006121121 A
- JP 2007238422 A
- JP 2007058170 A
- EP 1349006 A
- WO 2005029187 A
- WO 2004074930 A
- JP 2007171406 A
- JP 2007206216 A
- JP 2007206217 A
- JP 2007225701 A
- JP 2007225702 A
- JP 2007328243 A
- JP 4537377 B
- JP 4486516 B
- JP 2002148790 A
- JP 2001343742 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 2007506125 W
- JP 48064183 A
- JP 49043191 B
- JP 52030490 B
- JP 46043946 B
- JP 1040337 B
- JP 1040336 B
- JP 2025493 A
- JP 61022048 A
- JP 2001277740 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 62293247 A
- US 3458311 A
- JP 55049729 B
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- JP 5045885 A
- JP 6035174 A
- JP 2220061 A
- JP 60059351 A
- US 5148746 A
- US 5568768 A
- GB 2297719 A
- JP 58159533 A
- JP 3100554 A
- JP 62167253 B

**Non-patent literature cited in the description**


- Senryo Binran. 1970
- Saishin Ganryo Binran. 1977
- Saishin Ganryo Ouyo Gijutsu. CMC Publishing, 1986
- Insatsu Inki Gijutsu. CMC Publishing, 1984
- Kinzoku Sekken no Seishitsu to Ouyo. Insatsu Inki Gijutsu. CMC Publishing, 1984
- *Nippon Secchaku Kyokaishi,* 1984, vol. 20 (7), 300-308